# EUROPEAN PATENT APPLICATION

(11) **EP 4 832 697 A1**
(43) Date of publication of application: **28.10.2026**
(21) Application number: 25744462.0
(22) Date of filing: 09.01.2025
(51) Int. Cl.: H10F 77/12, H10F 77/10, H10F 77/20

(54) **SOLAR CELL AND MANUFACTURING METHOD THEREFOR, AND PHOTOVOLTAIC MODULE**

(30) Priority: 23.01.2024 CN 202410092536; 20.02.2024 CN 202410190935; 26.07.2024 CN 202411017051; 03.09.2024 CN 202411231900; 03.09.2024 CN 202411231282
(71) Applicant: Longi Green Energy Technology Co., Ltd., Xi'an, Shaanxi 710100 (CN)
(72) Inventor: YU, Mingzhe, Xi' an, Shaanxi 710100 (CN); SUN, Zhaoqing, Xi' an, Shaanxi 710100 (CN); HUANG, Zhipeng, Xi' an, Shaanxi 710100 (CN); TANG, Xiyan, Xi' an, Shaanxi 710100 (CN); DENG, Xiaoyu, Xi' an, Shaanxi 710100 (CN); QIU, Haoran, Xi' an, Shaanxi 710100 (CN); WU, Hua, Xi' an, Shaanxi 710100 (CN); CAO, Yujia, Xi' an, Shaanxi 710100 (CN); FANG, Liang, Xi' an, Shaanxi 710100 (CN); XU, Xixiang, Xi' an, Shaanxi 710100 (CN)
(74) Representative: Grünecker Patent- und Rechtsanwälte PartG mbB
(86) International application number: PCT/CN2025/071575
(87) International publication number: WO 2025/157018

(57) **Abstract**

The present application discloses a solar cell and a production method therefor, and a photovoltaic module. The solar cell includes: a semiconductor substrate, where the semiconductor substrate has a first surface and a second surface opposite to the first surface; and a first semiconductor layer provided on the first surface, where the first semiconductor layer includes a first part and a second part that is adjacent to the first part along a second direction. A degree of crystallization of the first part is higher than a degree of crystallization of the second part. The first semiconductor layer includes at least one of amorphous silicon, nanocrystalline silicon, and microcrystalline silicon. A crystallized region and an uncrystallized region that are both proper are provided on the first semiconductor layer, so that overall cell efficiency of the solar cell is optimized based on the higher degree of crystallization of the first part, thereby improving the cell efficiency. In addition, a passivation effect of the second part is ensured based on the lower degree of crystallization of the second part, thereby avoiding electric leakage.

## Description

### CROSS-REFERENCE TO RELATED APPLICATIONS

The present application claims priorities to Chinese Patent Application No. 202410092536.4, filed with the China National Intellectual Property Administration on January 23, 2024 and entitled "SOLAR CELL AND PREPARATION METHOD THEREFOR, AND BATTERY ASSEMBLY", to Chinese Patent Application No. 202410190935.4, filed with the China National Intellectual Property Administration on February 20, 2024 and entitled "SOLAR CELL AND PREPARATION METHOD THEREFOR, AND BATTERY ASSEMBLY", to Chinese Patent Application No. 202411017051.5, filed with the China National Intellectual Property Administration on July 26, 2024 and entitled "SOLAR CELL AND PRODUCTION METHOD THEREFOR, AND PHOTOVOLTAIC MODULE", to Chinese Patent Application No. 202411231900.7, filed with the China National Intellectual Property Administration on September 3, 2024 and entitled "SOLAR CELL AND PRODUCTION METHOD THEREFOR, AND PHOTOVOLTAIC MODULE", and to Chinese Patent Application No. 202411231282.6, filed with the China National Intellectual Property Administration on September 3, 2024 and entitled "SOLAR CELL AND PRODUCTION METHOD THEREFOR, AND PHOTOVOLTAIC MODULE", all of which are incorporated herein by reference in their entireties.

### TECHNICAL FIELD

The present application relates to the field of photovoltaic technologies, and in particular, to a solar cell and a production method therefor, and a photovoltaic module.

### BACKGROUND

In a structure of a solar cell, a semiconductor layer on a textured surface is processed by using laser. Some materials of the semiconductor layer include hydrogen. After the semiconductor layer including the hydrogen absorbs light, a temperature of the semiconductor layer increases, leading to escape of H in the semiconductor layer and an increase in effective doping. In addition, a contact resistance of the solar cell can be reduced after laser action, thereby reducing an energy loss in a current collection process, and improving cell efficiency. However, when a region processed by using the laser is improper, a risk of electric leakage in a part of regions of the solar cell may be large, and the cell efficiency is affected.

### SUMMARY

An objective of the present application is to provide a solar cell and a production method therefor, and a photovoltaic module, so as to reduce a contact resistance, reduce a risk of electric leakage, and improve cell efficiency.

To achieve the foregoing objective, the present application provides the following technical solutions:
A solar cell is provided, including:
a semiconductor substrate, where the semiconductor substrate has a first surface and a second surface opposite to the first surface; and
a first semiconductor layer provided on the first surface, where the first semiconductor layer includes a first part and a second part that is adjacent to the first part along a second direction, a degree of crystallization of the first part being higher than a degree of crystallization of the second part, and the first semiconductor layer including at least one of amorphous silicon, nanocrystalline silicon, and microcrystalline silicon.

When the foregoing technical solution is used, a crystallized structure is formed in the first part of the first semiconductor layer, so that the first part has both one part that is crystallized and the other part that is uncrystallized. Not all of the first part is a crystallized structure, but most of the first part is an uncrystallized structure, such as nanocrystalline. However, the second part adjacent to the first part along the second direction on the first semiconductor layer is not crystallized, and an original amorphous structure is retained (it should be noted that, when the first semiconductor layer includes nanocrystalline silicon or microcrystalline silicon, a degree of crystallization or crystallinity of nanocrystalline silicon or microcrystalline silicon of the second part remains unchanged), so that the overall degree of crystallization of the first part of the first semiconductor layer is higher than the overall degree of crystallization of the second part. It may be understood that, when other factors are the same, a lower degree of crystallization of a semiconductor layer indicates smaller grains in the semiconductor layer, and even randomness of an amorphous silicon material is presented. Smaller grains in the semiconductor layer indicate more boundaries between the grains in the semiconductor layer. Therefore, a resistance of the grain boundaries is large. Therefore, the crystallized structure in the first part of the first semiconductor layer reduces a contact resistance, so that a contact resistance between the first part and a conductive material (a transparent conductive layer or an electrode) is reduced, thereby helping reduce a transmission loss when carriers collected in the first semiconductor layer are transmitted to the conductive material. In addition, the degree of crystallization of the second part of the first semiconductor layer is lower than the degree of crystallization of the first part. This ensures a passivation effect of the second part adjacent to the first part along the second direction, and reduces recombination at an edge of the first semiconductor layer. To be specific, for a back contact solar cell, the second part of the first semiconductor layer is close to a second semiconductor layer, and the degree of crystallization of the second part is low, to ensure the passivation effect of the second part and avoid electric leakage between the second part and the second semiconductor layer. It can be known from the foregoing that a crystallized region and an uncrystallized region that are both proper are provided on the first semiconductor layer, so that overall cell efficiency of the solar cell is optimized based on the higher degree of crystallization of the first part, thereby improving the cell efficiency. In addition, the passivation effect of the second part is ensured based on the lower degree of crystallization of the second part, thereby avoiding electric leakage.

In an implementation, the solar cell further includes a second semiconductor layer provided on the first surface. The first semiconductor layer and the second semiconductor layer are arranged adjacently along the second direction. A conductivity type of the first semiconductor layer is different from a conductivity type of the second semiconductor layer. The second part is closer to the second semiconductor layer than the first part along the second direction. The second semiconductor layer has an adjacent side surface close to the first semiconductor layer. When the foregoing technical solution is used, for a back contact solar cell, the second part of the first semiconductor layer is closer to the second semiconductor layer, and the degree of crystallization of the second part is lower, to ensure the passivation effect of the second part, avoid electric leakage between the second part and the second semiconductor layer, and reduce photoelectric conversion efficiency of the solar cell.

In an implementation, the second semiconductor layer includes a third part and a fourth part that is adjacent to the third part along the second direction. A degree of crystallization of the third part is higher than a degree of crystallization of the fourth part. The second semiconductor layer includes at least one of amorphous silicon, nanocrystalline silicon, and microcrystalline silicon.

In an implementation, the second part extends from an edge of the first part toward the adjacent side surface along the second direction, but is not in contact with the adjacent side surface. When this technical solution is used, the second part is not in contact with the second semiconductor layer, and a spacing between the second part and the second semiconductor layer is large, to help further reduce potential electric leakage between the second part and the second semiconductor layer.

In an implementation, the second part extends from an edge of the first part to the adjacent side surface along the second direction, and is in contact with the adjacent side surface. When this technical solution is used, the second part overlaps with at least a part of the adjacent side surface of the second semiconductor layer, and the degree of crystallization of the second part is lower, so that a weak current can be transmitted through the second part and the adjacent side surface of the second semiconductor layer. When the solar cell is blocked, the current can pass through the second part and the adjacent side surface of the second semiconductor layer to form an electric leakage path, to prevent the blocked solar cell from becoming a load that consumes energy generated by another illuminated solar cell, thereby reducing a risk of a hot spot.

In an implementation, a distance between the edge of the first part and the adjacent side surface along the second direction is greater than or equal to 20 µm. Through such setting, it can be ensured that the first part having a strong current transmission capability is far away from the second semiconductor layer, thereby reducing potential electric leakage between the first part and the second semiconductor layer.

In an implementation, a part of the second part is disposed above the second semiconductor layer to form an overlapping part. The second part extends from an edge of the first part to the overlapping part along the second direction. In this technical solution, the second part is enabled to extend from the edge of the first part to the overlapping part, so that a current transmission capability between the second part and the second semiconductor layer can be improved. When the solar cell is blocked, a current can pass through the second part and a side surface away from the semiconductor substrate of the second semiconductor layer to form an electric leakage path. A current transmission capability of the electric leakage path is stronger, thereby further reducing the risk of a hot spot.

In an implementation, a width of the second part along the second direction is less than or equal to 500 µm and greater than or equal to 20 µm. Through such setting, when the width of the second part is set to be excessively large, for example, greater than 500 µm, the second part significantly blocks the second semiconductor layer, and consequently, effective current collection of the second semiconductor layer cannot be achieved, the electric leakage path is excessively large, and a cell efficiency loss is large. When the width of the second part is set to be excessively small, for example, less than 20 micrometers, it is difficult to control laser, and the laser may be irradiated on another part (for example, the second semiconductor layer), leading to a damage to the another part.

In an implementation, the solar cell further includes a first transparent conductive layer covering the first semiconductor layer. A projection of the first part on the semiconductor substrate completely falls within a projection of the first transparent conductive layer on the semiconductor substrate. Through such setting, the first transparent conductive layer is provided, so that a carrier transport capability of the first semiconductor layer is improved, and good Ohmic contact can be formed with an electrode, thereby improving electrical conductivity performance. The first part having the crystallized structure does not extend a boundary of the first transparent conductive layer, so that a contact resistance is reduced in an effective conductive region of the first transparent conductive layer, thereby improving the electrical conductivity performance and the cell efficiency.

In an implementation, the first transparent conductive layer extends, along the second direction, to the adjacent side surface or to the second part located above the second semiconductor layer. Through such setting, the first transparent conductive layer can cover a larger area of the first semiconductor layer, thereby further improving the electrical conductivity performance.

In an implementation, the solar cell further includes a second transparent conductive layer. The second transparent conductive layer covers the second semiconductor layer. A PN isolation region is provided between the second transparent conductive layer and the first transparent conductive layer. The PN isolation region is located on the second semiconductor layer. Electrical insulation between a P region and an N region is implemented by using the PN isolation region, and a projection of the first part falls within a boundary of the first transparent conductive layer. Therefore, the first part does not enter a boundary of the PN isolation region, so that an irradiation range of the laser does not enter the PN isolation region. Because the PN isolation region does not include a crystallized structure or has a low degree of crystallization, an electrical insulation effect of the PN isolation region is ensured.

In an implementation, a part of the second part is disposed above the second semiconductor layer to form an overlapping part. The PN isolation region is provided on the overlapping part.

In an implementation, the solar cell further includes a third semiconductor layer provided on the second surface. A material of the third semiconductor layer includes at least one of polycrystalline silicon, amorphous silicon, nanocrystalline silicon, and microcrystalline silicon. A conductivity type of the third semiconductor layer is different from a conductivity type of the first semiconductor layer. Through such setting, when the third semiconductor layer includes an amorphous silicon layer, an entire amorphous silicon layer is provided on both sides of the semiconductor substrate, and the amorphous silicon layers on both sides can form a heterojunction structure, thereby forming a bifacial heterojunction cell. When the third semiconductor layer includes polycrystalline silicon, a passivation structure of a polycrystalline silicon layer may be formed on the second surface, and a passivation structure of an amorphous silicon layer or a nanocrystalline silicon layer may be formed on the first surface, thereby forming a bifacial hybrid cell. Provided that an amorphous silicon layer and/or a nanocrystalline silicon layer is included, the bifacial heterojunction cell and the bifacial hybrid cell may also be applicable to a cell structure in which an edge is an uncrystallized structure and a middle region has a crystallized structure in the present application, to improve the cell efficiency.

In an implementation, the first part and the second part both extend in a strip shape along a first direction. The first direction intersects with the second direction. Specifically, the first part and the second part are disposed in approximately parallel strip shapes. In this way, the laser is simply moved gradually along the first direction in an irradiation process, thereby facilitating forming of laser irradiation on the first part.

In an implementation, a contact resistance of the first part is less than a contact resistance of the second part. The first part may have a crystallized structure, and the second part is an amorphous structure. Therefore, effective doping of the crystallized structure of the first part is increased, and a contact resistance of the first part can be reduced relative to that of the second part, thereby reducing an energy loss in a current collection process of the first part, and improving the cell efficiency.

In an implementation, the first part extends to an edge of the first surface along a first direction. In this way, a region of the first part can be enlarged as much as possible, thereby reducing a contact resistance, and improving a current collection capability.

In an implementation, the second part surrounds the first part. Through such setting, the second part surrounding the first part has a lower degree of crystallization, so that a risk of electric leakage can be further reduced, and photoelectric conversion efficiency of the solar cell can be ensured.

In an implementation, a material of the first part includes amorphous silicon and nanocrystalline silicon, and a material of the second part is amorphous silicon. Therefore, the second part has a good passivation effect. A crystallized region and an uncrystallized region that are both proper are provided on the first semiconductor layer, so that the overall cell efficiency of the solar cell is optimized, thereby improving the cell efficiency.

In an implementation, the semiconductor substrate includes a recessed part on the first surface. The recessed part is recessed toward a direction of the second surface relative to another part of the first surface. The first part is located inside the recessed part. Through such setting, the recessed part is formed through etching to a surface of the semiconductor substrate, and usually has a textured structure. When the first part having amorphous silicon, nanocrystalline silicon, and/or microcrystalline silicon is disposed in the recessed part, a contact area of the first part can be increased, thereby facilitating current collection.

In an implementation, the solar cell further includes a first grid electrode. The first grid electrode is stacked above the first semiconductor layer. A projection of the first grid electrode on the semiconductor substrate overlaps with a projection of the first part on the semiconductor substrate. A projection area of the first grid electrode on the semiconductor substrate is less than a projection area of the first part on the semiconductor substrate.

A photovoltaic module is provided, including a solar cell. The solar cell is the solar cell in any one of the foregoing implementations.

Because the photovoltaic module uses the solar cell in any one of the first aspect and the foregoing implementations, the photovoltaic module has beneficial effects the same as those of the first aspect, and details are not described herein again.

The present application further provides a production method for a solar cell. The method includes:
providing a semiconductor substrate, where the semiconductor substrate has a first surface and a second surface opposite to the first surface;
forming a first semiconductor layer located on the first surface, where the first semiconductor layer includes at least one of amorphous silicon, nanocrystalline silicon, and microcrystalline silicon; and
irradiating a first part of the first semiconductor layer by using laser, and skipping irradiating a second part of the first semiconductor layer, to enable a degree of crystallization of the first part to be higher than a degree of crystallization of the second part, where the first part is adjacent to the second part along a second direction. When the foregoing technical solution is used, crystallization processing is performed on a region corresponding to the first part located on the first semiconductor layer by using laser, so that a degree of crystallization is improved. A region corresponding to the second part adjacent to the first part on the first semiconductor layer is not irradiated by the laser, and an amorphous structure is retained (it should be noted that, when the first semiconductor layer includes nanocrystalline silicon or microcrystalline silicon, a degree of crystallization or crystallinity of nanocrystalline silicon or microcrystalline silicon of the second part remains unchanged), so that the overall degree of crystallization of the first part of the first semiconductor layer is higher than the overall degree of crystallization of the second part. It may be understood that, when other factors are the same, a lower degree of crystallization of a semiconductor layer indicates smaller grains in the semiconductor layer, and even randomness of an amorphous silicon material is presented. Smaller grains in the semiconductor layer indicate more boundaries between the grains in the semiconductor layer. Therefore, a resistance of the grain boundaries is large. Therefore, the crystallized structure in the first part of the first semiconductor layer reduces a contact resistance, so that a contact resistance between the first part and a conductive material (a transparent conductive layer or an electrode) is reduced, thereby helping reduce a transmission loss when carriers collected in the first semiconductor layer are transmitted to the conductive material. In addition, the degree of crystallization of the second part of the first semiconductor layer is lower than the degree of crystallization of the first part. This ensures a passivation effect of the second part adjacent to the first part along the second direction, and reduces recombination at an edge of the first semiconductor layer. To be specific, for a back contact solar cell, the second part of the first semiconductor layer is close to a second semiconductor layer, and the degree of crystallization of the second part is low, to ensure the passivation effect of the second part and avoid electric leakage between the second part and the second semiconductor layer. It can be known from the foregoing that a crystallized region and an uncrystallized region that are both proper are provided on the first semiconductor layer, so that overall cell efficiency of the solar cell is optimized based on the higher degree of crystallization of the first part, thereby improving the cell efficiency. In addition, the passivation effect of the second part is ensured based on the lower degree of crystallization of the second part, thereby avoiding electric leakage.

In an implementation, the first semiconductor layer is an amorphous silicon layer. A part of the amorphous silicon layer is crystallized to form nanocrystalline grains after the first part is irradiated by the laser. When the first semiconductor layer uses the amorphous silicon layer, a part that is not irradiated by the laser has a good passivation effect, and an isolation region has a better insulation effect.

In an implementation, before the first part is irradiated by using the laser, the method further includes: forming a second semiconductor layer on the first surface. The first semiconductor layer and the second semiconductor layer are arranged adjacently along the second direction. A conductivity type of the first semiconductor layer is different from a conductivity type of the second semiconductor layer. The second semiconductor layer has an adjacent side surface close to the first semiconductor layer. The second part is closer to the second semiconductor layer than the first part. For a back contact solar cell, the second part of the first semiconductor layer is closer to the second semiconductor layer, and the degree of crystallization of the second part is lower, to ensure the passivation effect of the second part, avoid electric leakage between the second part and the second semiconductor layer, and reduce photoelectric conversion efficiency of the solar cell.

In an implementation, the first part extends in a strip shape along a first direction. The irradiating a first part by using laser includes: irradiating the first part along the first direction by using the laser. A start or end position of the laser is away from the adjacent side surface by a first distance along the second direction. There is a spacing between an end away from the first part of the second part and the adjacent side surface. The second part is not in contact with the second semiconductor layer, and a spacing between the second part and the second semiconductor layer is large, to help further reduce potential electric leakage between the second part and the second semiconductor layer.

In an implementation, the start or end position of the laser is away from a boundary of the first semiconductor layer by a second distance along the first direction. The second distance is a distance by which the second part extends along the first direction. Due to the second distance, two ends of the first semiconductor layer along the first direction are not irradiated by the laser, and an amorphous structure is retained, thereby ensuring a passivation effect of an edge part, and reducing recombination of the edge part.

In an implementation, the second distance is greater than the first distance.

In an implementation, a wavelength of the laser ranges from 325 nm to 532 nm; and/or an energy density of the laser ranges from 200 mJ/cm² to 6000 mJ/cm². The range of the wavelength is set, so that the laser can be absorbed by the amorphous semiconductor layer, thereby helping implement crystallization of the amorphous semiconductor layer. When the energy density of the laser is excessively high, a high-temperature range may be expanded, and a temperature at a top of a textured structure may be excessively high. Consequently, passivation of a top region of the textured structure is affected. When the energy density of the laser is excessively low, energy accumulation duration is excessively long, affecting production efficiency, and energy required for crystallization may not be reached. Therefore, when the energy density of the laser in this range is selected, only the top of the textured structure reaches a high temperature, so that a topography changes, and a crystallized structure is formed.

### BRIEF DESCRIPTION OF THE DRAWINGS

The accompanying drawings described herein are used to provide a further understanding of the present application, and form a part of the present application. Exemplary embodiments of the present application and descriptions thereof are used to explain the present application, and do not constitute any inappropriate limitation to the present application. In the accompanying drawings:
FIG. 1 is a schematic diagram of a solar cell according to an embodiment of the present application;
FIG. 2 is a schematic diagram of another solar cell according to an embodiment of the present application;
FIG. 3 is a schematic diagram of partial arrangement of a transparent conductive layer on a first surface of a solar cell according to an embodiment of the present application;
FIG. 4 is a partial enlarged view of FIG. 3 according to an embodiment of the present application;
FIG. 5 is a schematic diagram of a section B-B in FIG. 4;
FIG. 6 is a schematic diagram of a section A-A in FIG. 4;
FIG. 7 to FIG. 18 are schematic flowcharts of steps of a production method for a solar cell according to an embodiment of the present application;
FIG. 19 is a schematic diagram of comparison between EL images of a solar cell (B in the figure) according to an embodiment of the present application and an existing solar cell (C in the figure) without a crystallized region;
FIG. 20 is a schematic diagram of comparison between P-region contact resistances of a solar cell according to an embodiment of the present application and an existing solar cell without a crystallized region;
FIG. 21 is a schematic diagram of crystallization at a top of a pyramid according to an embodiment of the present application; and
FIG. 22 is a schematic diagram of still another solar cell according to an embodiment of the present application.

### Reference numerals:

100: first semiconductor layer; 1: first strip-shaped portion; 11: first part; 12: second part; 13: intrinsic amorphous silicon layer; 14: p-type amorphous silicon layer; 15: overlapping part; 2: second semiconductor layer; 201: third part; 202: fourth part; 21: tunneling oxide layer; 22: N-type doped polycrystalline silicon layer; 23: intrinsic polycrystalline silicon layer; 24: phosphosilicate glass layer; 25: silicon nitride mask layer; 3: edge isolation region; 4: first grid electrode; 5: second grid electrode; 6: semiconductor substrate; 7: transparent conductive layer; 71: first transparent conductive layer; 72: second transparent conductive layer; 73: third transparent conductive layer; 8: passivation layer; 9: anti-reflection layer; and 10: PN isolation region.

### DETAILED DESCRIPTION

To make the technical problems to be resolved by, the technical solutions, and the beneficial effects of the present application clearer and more comprehensible, the following describes the present application in further detail with reference to the accompanying drawings and embodiments. It should be understood that the specific embodiments described herein are merely used for describing the present application and are not intended to limit the present application.

It should be noted that, when an element is described as being "fixed to" or "arranged on" another element, the element may be directly located on the another element or indirectly located on the another element. When an element is described as "being connected to" another element, the element may be directly connected to the another element, or may be indirectly connected to the another element.

In addition, the terms "first" and "second" are merely intended for a purpose of description, and shall not be understood as indicating or implying relative significance or implicitly indicating a quantity of indicated technical features. Therefore, features defining "first" and "second" can explicitly or implicitly include one or more of the features. In the descriptions of the present application, unless clearly and specifically defined otherwise, "a plurality of" means two or more. Unless clearly and specifically defined otherwise, "several" means one or more.

In the descriptions of the present application, it should be understood that orientation or position relationships indicated by the terms such as "on", "below", "front", "rear", "left", "right", and the like are based on orientation or position relationships shown in the accompanying drawings, and are used only for ease and brevity of illustration of the present application and description, rather than indicating or implying that the mentioned device or element must have a particular orientation or must be constructed and operated in a particular orientation. Therefore, such terms should not be construed as a limitation to the present application.

In the descriptions of the present application, it should be noted that, unless otherwise explicitly specified or limited, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two components, or an interaction relationship between two components. A person of ordinary skill in the art may understand specific meanings of the terms in the present application according to specific situations.

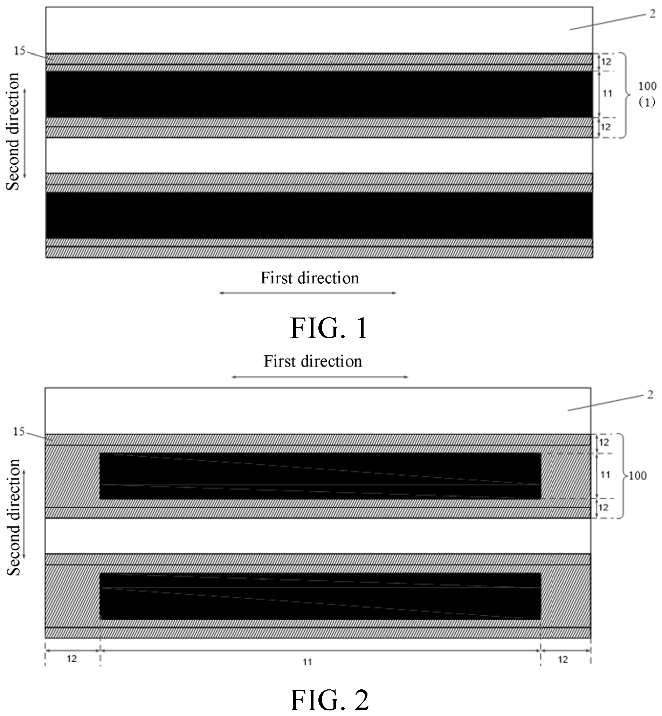

As shown in FIG. 1 to FIG. 6, an embodiment of the present application provides a solar cell, including a semiconductor substrate 6 and a first semiconductor layer 100. The semiconductor substrate 6 has a first surface and a second surface opposite to the first surface. The first semiconductor layer 100 is provided on the first surface of the semiconductor substrate 6. The first semiconductor layer 100 includes a first part 11 and a second part 12. The first part 11 and the second part 12 are adjacent to each other along a second direction. To be specific, along the second direction, both sides of the first part 11 are disposed adjacent to the second part 12, or one side of the first part 11 is disposed adjacent to the second part 12.

A degree of crystallization of the first part 11 is higher than a degree of crystallization of the second part 12. The first semiconductor layer 100 includes at least one of amorphous silicon, nanocrystalline silicon, and microcrystalline silicon. To be specific, the first semiconductor layer 100 may be an amorphous silicon layer, a nanocrystalline silicon layer, or a microcrystalline silicon layer. Alternatively, the first semiconductor layer 100 may be a combination of any two or three of amorphous silicon, nanocrystalline silicon, and microcrystalline silicon. Degree of crystallizations of the amorphous silicon, the nanocrystalline silicon, and the microcrystalline silicon may be improved after the amorphous silicon, the nanocrystalline silicon, and the microcrystalline silicon are crystallized by using laser. For example, when the first semiconductor layer 100 is an amorphous silicon layer, when a part of the amorphous silicon layer is crystallized by using the laser, nanocrystalline grains are formed. The nanocrystalline silicon refers to a crystallized structure in which sizes of most grains are at the nanoscale, for example, less than 200 nm. When the first semiconductor layer 100 includes a nanocrystalline silicon layer or a microcrystalline silicon layer, when a part is crystallized by using the laser, a crystallinity or degree of crystallization of the first semiconductor layer 100 may be improved.

In an actual application process, a material of a conductivity type of the semiconductor substrate 6 are not specifically limited in this embodiment of the present application. For example, the semiconductor substrate 6 may be a silicon substrate. Alternatively, the semiconductor substrate 6 may be a substrate of any semiconductor material, such as a silicon-germanium substrate, a germanium substrate, or a gallium arsenide substrate. The conductivity type of the semiconductor substrate 6 may be an N-type semiconductor substrate, a P-type semiconductor substrate, or an intrinsic semiconductor substrate.

The semiconductor substrate 6 has the first surface and the second surface opposite to the first surface. The first surface of the semiconductor substrate 6 may correspond to a light receiving surface of the solar cell. In this case, the second surface of the semiconductor substrate 6 corresponds to a back surface of the solar cell. Alternatively, the first surface of the semiconductor substrate 6 may correspond to a back surface of the solar cell. In this case, the second surface of the semiconductor substrate 6 corresponds to a light receiving surface of the solar cell.

When the foregoing technical solution is used, a crystallized structure is formed in the first part 11 of the first semiconductor layer 100, so that the first part 11 has both one part that is crystallized and the other part that is uncrystallized. Not all of the first part 11 is a crystallized structure, but most of the first part 11 is an uncrystallized structure, such as nanocrystalline. However, the second part 12 adjacent to the first part 11 along the second direction on the first semiconductor layer 100 is not crystallized, and an original amorphous structure is retained (it should be noted that, when the first semiconductor layer 100 includes nanocrystalline silicon or microcrystalline silicon, a degree of crystallization or crystallinity of nanocrystalline silicon or microcrystalline silicon of the second part 12 remains unchanged), so that the overall degree of crystallization of the first part 11 of the first semiconductor layer 100 is higher than the overall degree of crystallization of the second part 12. It may be understood that, when other factors are the same, a lower degree of crystallization of a semiconductor layer indicates smaller grains in the semiconductor layer, and even randomness of an amorphous silicon material is presented. Smaller grains in the semiconductor layer indicate more boundaries between the grains in the semiconductor layer. Therefore, a resistance of the grain boundaries is large. Therefore, the crystallized structure in the first part 11 of the first semiconductor layer 100 reduces a contact resistance, so that a contact resistance between the first part 11 and a conductive material (a transparent conductive layer or an electrode) is reduced, thereby helping reduce a transmission loss when carriers collected in the first semiconductor layer 100 are transmitted to the conductive material. In addition, the degree of crystallization of the second part 12 of the first semiconductor layer 100 is lower than the degree of crystallization of the first part 11. This ensures a passivation effect of the second part 12 adjacent to the first part 11 along the second direction, and reduces recombination at an edge of the first semiconductor layer 100. To be specific, for a back contact solar cell, the second part 12 of the first semiconductor layer 100 is close to a second semiconductor layer 2, and the degree of crystallization of the second part 12 is low, to ensure the passivation effect of the second part 12 and avoid electric leakage between the second part 12 and the second semiconductor layer 2. It can be known from the foregoing that a crystallized region and an uncrystallized region that are both proper are provided on the first semiconductor layer 100, so that overall cell efficiency of the solar cell is optimized based on the higher degree of crystallization of the first part 11, thereby improving the cell efficiency. In addition, the passivation effect of the second part 12 is ensured based on the lower degree of crystallization of the second part 12, thereby avoiding electric leakage.

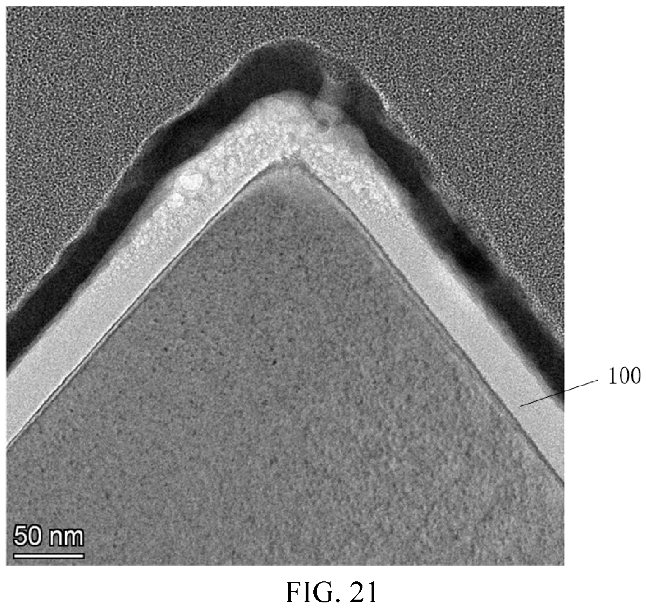

It may be understood that, when at least a partial region of the first surface of the semiconductor substrate 6 is a textured surface, the textured surface includes a plurality of quasi-pyramids. As shown in FIG. 21, the first semiconductor layer 100 is provided on a textured surface in a conformal manner. A degree of crystallization of a part covered by the first semiconductor layer 100 at a top of at least a part of quasi-pyramids is higher than a degree of crystallization of another part covered by the first semiconductor layer 100 at a base portion of the quasi-pyramid. In a process in which a degree of crystallization of the first semiconductor layer 100 is observed, when an observed region is excessively small, and only a base region of the quasi-pyramid is observed, the degree of crystallization of the first semiconductor layer 100 cannot be accurately obtained. Therefore, the observed region needs to include at least one quasi-pyramid. In an embodiment, the observed region needs to be greater than or equal to 5 * 5 µm², to avoid a case that the degree of crystallization of the first semiconductor layer 100 cannot be accurately obtained when only the base region of the quasi-pyramid is observed.

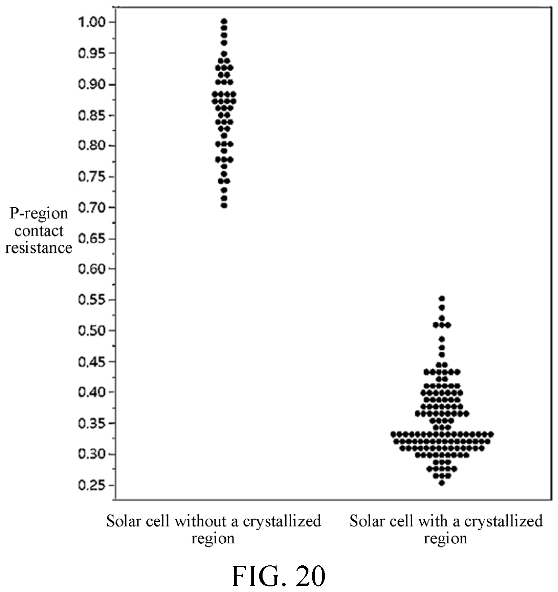

In some possible implementations, a contact resistance of the first part 11 is less than a contact resistance of the second part 12. The first part 11 may have a crystallized structure or a higher degree of crystallization, and the second part 12 is an amorphous structure or has a lower degree of crystallization. Therefore, effective doping of the first part 11 is increased, and a contact resistance of the first part 11 can be reduced relative to that of the second part 12, thereby reducing an energy loss in a current collection process of the first part 11, and improving the cell efficiency. For example, as shown in FIG. 20, when the first semiconductor layer 100 is provided in a P region, through comparison between P-region contact resistances of a solar cell without a crystallized region and a solar cell with a crystallized region, it can be learned that an overall contact resistance of a solar cell having the first part 11 on the first semiconductor layer 100 is less than an overall contact resistance of a solar cell not having the first part 11 on the first semiconductor layer 100.

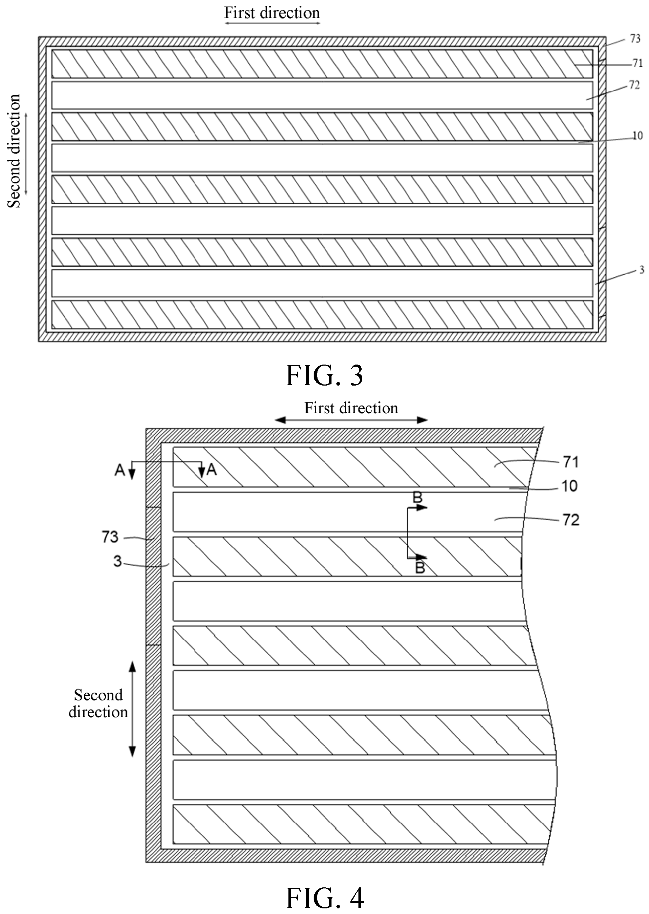

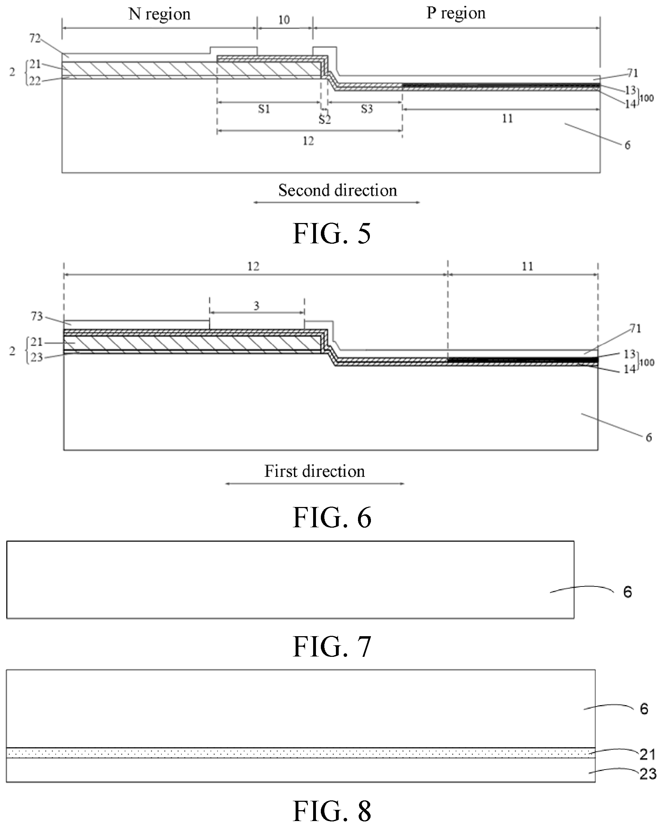

As shown in FIG. 1, in this embodiment, the solar cell further includes the second semiconductor layer 2 provided on the first surface. The first semiconductor layer 100 and the second semiconductor layer 2 are arranged adjacently along the second direction. To be specific, the solar cell is a back contact solar cell, the first semiconductor layer 100 and the second semiconductor layer 2 are both provided on the first surface, and the first semiconductor layer 100 and the second semiconductor layer 2 are provided adjacently along the second direction. As shown in FIG. 4 and FIG. 5, the second semiconductor layer 2 has an adjacent side surface close to the first semiconductor layer 100. The second part 12 is closer to the second semiconductor layer 2 than the first part 11 along the second direction. To be specific, the second part 12 is located between the first part 11 and the second semiconductor layer 2 along the second direction. A conductivity type of the first semiconductor layer 100 is different from a conductivity type of the second semiconductor layer 2. To implement arrangement of a P region and an N region on the first surface, the first semiconductor layer 100 is one of the P region and the N region, and the second semiconductor layer 2 is the other of the P region and the N region.

When the foregoing technical solution is used, for a back contact solar cell, the second part 12 of the first semiconductor layer 100 is closer to the second semiconductor layer 2, and the degree of crystallization of the second part 12 is lower, to ensure the passivation effect of the second part 12, avoid electric leakage between the second part 12 and the second semiconductor layer 2, and reduce photoelectric conversion efficiency of the solar cell.

In the foregoing technical solution, as shown in FIG. 1, the first semiconductor layer 100 may include a plurality of first strip-shaped portions 1 extending along a first direction, and the second semiconductor layer 2 may include a plurality of second strip-shaped portions extending along the first direction. The first strip-shaped portions 1 and the second strip-shaped portions are alternately arranged along the second direction, and the first direction intersects with the second direction. In this embodiment, the entire first strip-shaped portion 1 extends along the first direction, and a width direction of the first strip-shaped portion 1 is the same as the second direction. The first strip-shaped portion 1 includes a first part 11 and a second part 12 adjacent to the first part 11 along the width direction of the first strip-shaped portion 1, in other words, the first part 11 and the second part 12 are adjacent to each other along the width direction of the first strip-shaped portion 1. The second part 12 is disposed closer to the second strip-shaped portion, and the second part 12 is located between the first part 11 and the second strip-shaped portion, to avoid electric leakage between the second part 12 and the second strip-shaped portion. In this embodiment, in a structure of the first strip-shaped portion 1, the second part 12 may be disposed on both sides of the first part 11 along the second direction, to further reduce a risk of electric leakage.

As shown in FIG. 1 and FIG. 2, in this embodiment, the first part 11 and the second part 12 both extend in a strip shape along a first direction. The first direction intersects with the second direction. Specifically, the first part 11 and the second part 12 are disposed in approximately parallel strip shapes. In this way, the laser is simply moved gradually along the first direction in an irradiation process, thereby facilitating forming of laser irradiation on the first part 11.

As shown in FIG. 5, in some embodiments, the second part 12 extends from an edge of the first part 11 toward the adjacent side surface along the second direction, but is not in contact with the adjacent side surface. Specifically, the second part 12 extends from the edge of the first part 11 to a region S3 shown in FIG. 5, that is, there is a spacing between an end away from the first part 11 of the second part 12 and the adjacent side surface. When this technical solution is used, the second part 12 is not in contact with the second semiconductor layer 2, and a spacing between the second part 12 and the second semiconductor layer 2 is large, to help further reduce potential electric leakage between the second part 12 and the second semiconductor layer 2.

As shown in FIG. 5, in some other embodiments, the second part 12 extends from an edge of the first part 11 to the adjacent side surface along the second direction, and is in contact with the adjacent side surface. Specifically, the second part 12 extends from the edge of the first part 11 to a region S2 shown in FIG. 5, that is, an end away from the first part 11 of the second part 12 is in contact with the adjacent side surface, and the second part 12 overlaps with at least a part of the adjacent side surface. When this technical solution is used, the second part 12 overlaps with at least a part of the adjacent side surface of the second semiconductor layer 2, and the degree of crystallization of the second part 12 is lower, so that a weak current can be transmitted through the second part 12 and the adjacent side surface of the second semiconductor layer 2. When the solar cell is blocked, the current can pass through the second part 12 and the adjacent side surface of the second semiconductor layer 2 to form an electric leakage path, to prevent the blocked solar cell from becoming a load that consumes energy generated by another illuminated solar cell, thereby reducing a risk of a hot spot.

Further, in the foregoing technical solution, a distance between the edge of the first part 11 and the adjacent side surface along the second direction is greater than or equal to 20 µm. Through such setting, it can be ensured that the first part 11 having a strong circuit transmission capability is far away from the second semiconductor layer 2, thereby reducing potential electric leakage between the first part 11 and the second semiconductor layer 2. For example, the distance between the edge of the first part 11 and the adjacent side surface is 20 µm, 22 µm, 24 µm, 25 µm, 50 µm, 70 µm, or 100 µm.

As shown in FIG. 5, in some other embodiments, a part of the second part 12 is disposed above the second semiconductor layer 2 to form an overlapping part 15. To be specific, a part of the second part 12 extends above the second semiconductor layer 2, and a part of the second part 12 that is located on a side away from the semiconductor substrate 6 of the second semiconductor layer 2 is the overlapping part 15. The second part 12 extends from the edge of the first part 11 to the overlapping part 15 along the second direction. Specifically, the second part 12 extends from the edge of the first part 11 to a region S1 shown in FIG. 5, that is, an end away from the first part 11 of the second part 12 is in contact with the side away from the semiconductor substrate 6 of the second semiconductor layer 2. Because a current transmission capability of a surface on the side away from the semiconductor substrate 6 of the second semiconductor layer 2 is stronger than that of the adjacent side surface, in this technical solution, the second part 12 is enabled to extend from the edge of the first part 11 to the overlapping part 15, so that a current transmission capability between the second part 12 and the second semiconductor layer 2 can be improved. When the solar cell is blocked, a current can pass through the second part 12 and a side surface away from the semiconductor substrate 6 of the second semiconductor layer 2 to form an electric leakage path. A current transmission capability of the electric leakage path is stronger, thereby further reducing the risk of a hot spot.

In some embodiments, a width of the second part 12 along the second direction is less than or equal to 500 µm and greater than or equal to 20 µm. As shown in FIG. 5, an extension distance of the second part 12 along the second direction is less than or equal to 500 µm and greater than or equal to 20 µm. Through such setting, when the width of the second part 12 is set to be excessively large, for example, greater than 500 µm, the second part 12 significantly blocks the second semiconductor layer 2, and consequently, effective current collection of the second semiconductor layer 2 cannot be achieved, the electric leakage path is excessively large, and a cell efficiency loss is large. When the width of the second part 12 is set to be excessively small, for example, less than 20 micrometers, it is difficult to control a crystallization craft such as laser, and another part (for example, the second semiconductor layer 2) may be processed, leading to a damage to the another part. For example, the width of the second part 12 along the second direction may be 100 µm, 90 µm, or 80 µm. In an embodiment, the width of the second part 12 along the second direction is greater than or equal to 100 µm, and less than or equal to 400 µm. Through such design, the second part 12 may be at least partially in contact with the second semiconductor layer 2 to form the electric leakage path, and a case that the second part 12 overlaps with the second semiconductor layer 2 excessively greatly, leading to a decrease in a current collection area of the second semiconductor layer 2, is avoided.

As shown in FIG. 3 and FIG. 4, in some possible implementations, the solar cell further includes a first transparent conductive layer 71 covering the first semiconductor layer 100. A projection of the first part 11 on the semiconductor substrate 6 completely falls within a projection of the first transparent conductive layer 71 on the semiconductor substrate 6. Through such setting, the first transparent conductive layer 71 is provided, so that a carrier transport capability of the first semiconductor layer 100 is improved, and good Ohmic contact can be formed with an electrode, thereby improving electrical conductivity performance. The first part 11 having the crystallized structure does not extend a boundary of the first transparent conductive layer 71, so that a contact resistance is reduced in an effective conductive region of the first transparent conductive layer 71, thereby improving the electrical conductivity performance and the cell efficiency.

Further, as shown in FIG. 5, in the foregoing technical solution, the first transparent conductive layer 71 extends, along the second direction, to the adjacent side surface or to the second part 12 located above the second semiconductor layer 2. Specifically, along the second direction, the first transparent conductive layer 71 may extend to the region S2 shown in FIG. 5, or the first transparent conductive layer 71 may extend to the region S1 shown in FIG. 5. Through such setting, the first transparent conductive layer 71 can cover a larger area of the first semiconductor layer 100, thereby further improving the electrical conductivity performance.

Further, as shown in FIG. 3 and FIG. 4, in some embodiments, the solar cell further includes a second transparent conductive layer 72. The second transparent conductive layer 72 covers the second semiconductor layer 2. A PN isolation region 10 is provided between the second transparent conductive layer 72 and the first transparent conductive layer 71. The PN isolation region 10 is located on the second semiconductor layer 2. When the foregoing technical solution is used, electrical insulation between a P region and an N region is implemented by using the PN isolation region 10, and a projection of the first part 11 falls within a boundary of the first transparent conductive layer 71. Therefore, the first part 11 does not enter a boundary of the PN isolation region 10, so that an irradiation range of the laser does not enter the PN isolation region 10. Because the PN isolation region 10 does not include a crystallized structure or has a low degree of crystallization, an electrical insulation effect of the PN isolation region 10 is ensured.

As shown in FIG. 3 and FIG. 4, the solar cell may further include a third transparent conductive layer 73. The third transparent conductive layer 73 covers a part of the second part 12. In this embodiment, the first transparent conductive layer 71 covers the first part 11, and there is an edge isolation region 3 between the first transparent conductive layer 71 and the third transparent conductive layer 73.

Further, as shown in FIG. 5 to FIG. 7, the first transparent conductive layer 71, the second transparent conductive layer 72, and the third transparent conductive layer 73 each may be at least one of fluorine-doped tin oxide, aluminum-doped zinc oxide, indium tin oxide, tungsten-doped indium oxide, indium molybdenum oxide, cerium-doped indium oxide, and indium hydroxide. The transparent conductive layer may be a single-layer film, or may be a laminated film.

For example, as shown in FIG. 5, a part of the second part 12 is disposed above the second semiconductor layer 2 to form an overlapping part 15. The PN isolation region 10 is provided on the overlapping part 15. For example, when the second semiconductor layer 2 includes a tunneling oxide layer 21 and an N-type doped polycrystalline silicon layer 22 that are stacked, and the first semiconductor layer 100 includes an intrinsic amorphous silicon layer 13 and a p-type amorphous silicon layer 14 that are stacked, the first semiconductor layer 100 laps the second semiconductor layer 2 at a junction between the first semiconductor layer 100 and the second semiconductor layer 2, to form the overlapping part 15. In this case, the PN isolation region 10 is located across the overlapping part 15. A width of the overlapping part 15 needs to be properly set, for example, may range from 100 µm to 300 µm, to balance the foregoing electric leakage path and current collection. The width of the second part 12 directly affects the width of the overlapping part 15. Because there is a distance between the first part 11 and the adjacent side surface of the second semiconductor layer 2, it is proper for the width of the overlapping part 15 to range from 100 µm to 300 µm.

In some embodiments, when the first surface of the solar cell has the first semiconductor layer 100 and the second semiconductor layer 2, that is, when the solar cell is a back contact solar cell, the second semiconductor layer 2 may include amorphous silicon, nanocrystalline silicon, and/or microcrystalline silicon. The second semiconductor layer 2 has a structure similar to that of the first semiconductor layer 100, but has a conductivity type different from that of the first semiconductor layer 100. To be specific, the second semiconductor layer 2 also has a first part and a second part that are adjacent to each other along the second direction, which are specifically a third part 201 and a fourth part 202 below. All regions of the third part 201 of the second semiconductor layer 2 may be laser-crystallized regions, or not all the regions are laser-crystallized regions. Refer to descriptions of the first part 11 of the first semiconductor layer 100 above, and details are not described herein again.

For example, the first semiconductor layer 100 corresponds to a P region, and the second semiconductor layer 2 corresponds to an N region. In this case, the first semiconductor layer 100 may include a first intrinsic amorphous silicon layer and a p-type amorphous silicon layer that are stacked, and the second semiconductor layer 2 may include a second intrinsic amorphous silicon layer and an N-type amorphous silicon layer hat are stacked. The first intrinsic amorphous silicon layer and the second intrinsic amorphous silicon layer are both provided close to the semiconductor substrate 6. Certainly, the conductivity type of the first semiconductor layer 100 and the conductivity type of the second semiconductor layer 2 are interchangeable, and details are not described again.

Through such setting, for the first semiconductor layer 100 and the second semiconductor layer 2 that are provided on the first surface and have different conductivity types, both the first semiconductor layer 100 and the second semiconductor layer 2 may form a heterojunction structure, to form a heterojunction back contact solar cell having both a P-region heterojunction structure and an N-region heterojunction structure on a back surface. The solar cell has advantages of a good passivation effect, high conversion efficiency, a long service life, and low preparation energy consumption of the heterojunction structure. Provided that an amorphous silicon layer and/or a nanocrystalline silicon layer is included, the heterojunction back contact solar cell may also be applicable to a cell structure in which an edge is an uncrystallized structure and a middle region is a crystallized structure in the present application, to improve the cell efficiency.

As shown in FIG. 1 to FIG. 6, in some embodiments, when the first surface of the solar cell has the first semiconductor layer 100 and the second semiconductor layer 2, that is, when the solar cell is a back contact solar cell, the second semiconductor layer 2 may be at least one of a polycrystalline silicon layer, a nanocrystalline silicon layer, and a microcrystalline silicon layer, and the first semiconductor layer 100 may be a heterojunction structure. When the second semiconductor layer 2 is a polycrystalline silicon layer, a tunneling passivated contact structure may be formed, and the conductivity type of the second semiconductor layer 2 is different from the conductivity type of the first semiconductor layer 100.

For example, the second semiconductor layer 2 may include a tunneling oxide layer 21 and a doped polycrystalline silicon layer that are stacked and provided on the first surface. The tunneling oxide layer 21 is provided close to the semiconductor substrate 6. Using an example in which the second semiconductor layer 2 corresponds to an N region, and the first semiconductor layer 100 corresponds to a P region, the doped polycrystalline silicon layer of the second semiconductor layer 2 is an N-type doped polycrystalline silicon layer 22. The first semiconductor layer 100 includes an intrinsic amorphous silicon layer 13 and a p-type amorphous silicon layer 14 that are stacked and provided on the first surface, and the intrinsic amorphous silicon layer 13 is provided close to the semiconductor substrate 6. Certainly, when the second semiconductor layer 2 is provided corresponding to a P region and the first semiconductor layer 100 is provided corresponding to an N region, the doped polycrystalline silicon layer is a p-type doped polycrystalline silicon layer, and the doped amorphous silicon layer in the first semiconductor layer 100 is an N-type amorphous silicon layer.

Through such setting, the second semiconductor layer 2 and the first semiconductor layer 100 that have different conductivity types are provided on the first surface, so that a hybrid back contact solar cell having both a tunneling passivated contact structure and a heterojunction structure on a back surface is formed. The first semiconductor layer 100 is the heterojunction structure. The solar cell has advantages of high conversion efficiency, good stability, and low Auger recombination of the tunneling passivated contact structure and advantages of a good passivation effect, high conversion efficiency, a long service life, and low preparation energy consumption of the heterojunction structure. Provided that an amorphous silicon layer and/or a nanocrystalline silicon layer is included, the hybrid back contact solar cell may also be applicable to a cell structure in which an edge is an uncrystallized structure and a middle region is a crystallized structure in the present application, to improve the cell efficiency. Certainly, when the second semiconductor layer 2 is another semiconductor layer, for example, microcrystalline silicon or nanocrystalline silicon, a heterojunction structure may also be formed. Different materials of the second semiconductor layer 2 are selected, so that a back contact solar cell in which a P region and an N region have different structures can be formed.

In some other embodiments, the solar cell further includes a third semiconductor layer provided on the second surface. A material of the third semiconductor layer includes at least one of polycrystalline silicon, amorphous silicon, nanocrystalline silicon, and microcrystalline silicon. A conductivity type of the third semiconductor layer is different from a conductivity type of the first semiconductor layer 100. For example, when an amorphous silicon layer covers the entire second surface, the third semiconductor layer may also form a heterojunction structure. A structure of the third semiconductor layer may be similar to that of the first semiconductor layer 100, and also has a first part 11 and a second part 12. A degree of crystallization of the first part 11 is higher than a degree of crystallization of the second part 12.

In an example, when the conductivity type of the first semiconductor layer 100 is a P-type, and the conductivity type of the third semiconductor layer is an N-type, the first semiconductor layer 100 includes a first intrinsic amorphous silicon layer and a p-type amorphous silicon layer that are stacked and provided on the first surface, the first intrinsic amorphous silicon layer is provided close to the first surface, the third semiconductor layer includes a third intrinsic amorphous silicon layer and an N-type amorphous silicon layer that are stacked and provided on the second surface, and the third intrinsic amorphous silicon layer is provided close to the second surface, to form a bifacial heterojunction cell. Certainly, the conductivity type of the first semiconductor layer 100 may alternatively be an N-type, and the conductivity type of the third semiconductor layer is a P-type. Details are not described.

In another example, a polycrystalline silicon layer is provided on the second surface. In this case, the third semiconductor layer may form a tunneling passivated contact structure. Specifically, the conductivity type of the first semiconductor layer 100 is a P-type, and the conductivity type of the third semiconductor layer is an N-type. In this case, the first semiconductor layer 100 includes a first intrinsic amorphous silicon layer and a p-type amorphous silicon layer that are stacked and provided on the first surface, and the first intrinsic amorphous silicon layer is provided close to the first surface. The third semiconductor layer includes an N-type doped polycrystalline silicon layer provided on the second surface. A tunneling oxide layer is further provided between the N-type doped polycrystalline silicon layer and the second surface. The tunneling oxide layer and the N-type doped polycrystalline silicon layer form the tunneling passivated contact structure. The third semiconductor layer may be locally provided on the second surface, for example, may be provided in a plurality of strip shapes. In this case, a poly-finger structure is formed, and a doped field region may be selectively formed on the substrate between poly-fingers. Alternatively, all the third semiconductor layer may be formed on the second surface. The third semiconductor layer has a part with a large thickness in a metalized contact region, and has a part with a small thickness in a non-metalized region. The first semiconductor layer 100 may be a heterojunction structure, to form a bifacial hybrid solar cell. Certainly, the conductivity type of the first semiconductor layer 100 may alternatively be an N-type, and the conductivity type of the third semiconductor layer is a P-type. Details are not described.

Provided that an amorphous silicon layer, a nanocrystalline silicon layer, and/or a microcrystalline silicon layer is included, the bifacial heterojunction cell and the bifacial hybrid solar cell may also be applicable to a cell structure in which the degree of crystallization of the first part 11 is higher than the degree of crystallization of the second part 12 in the present application, to improve the cell efficiency.

In some possible implementations, as shown in FIG. 1, the first part 11 extends to an edge of the first surface along a first direction. To be specific, two ends of the first part 11 extend to the edge of the first surface of the semiconductor substrate 6 along the first direction. In this way, a region of the first part 11 can be enlarged as much as possible, thereby reducing a contact resistance, and improving a current collection capability. It should be noted that, because a part of the first semiconductor layer 100 close to an edge of the semiconductor substrate 6 has a large defect, a poor passivation effect, severe current leakage, and severe recombination, a part of the first part 11 close to the edge of the first surface of the semiconductor substrate 6 may not be used as a current collection region.

In some other possible implementations, as shown in FIG. 2, the second part 12 may surround the first part 11. Specifically, the second part 12 is disposed on both sides of the first part 11 regardless of along the first direction or along the second direction, and the second part 12 entirely encircles the first part 11. Through such setting, the second part 12 surrounding the first part 11 has a lower degree of crystallization, so that a risk of electric leakage can be further reduced, and photoelectric conversion efficiency of the solar cell can be ensured.

In the foregoing technical solution, the first part 11 is in a rectangular shape, and the second part 12 is in an annular shape. To be specific, the first part 11 located in a middle region is correspondingly in a rectangular shape, and the second part 12 located in an edge region is correspondingly in an annular shape. The entire first semiconductor layer 100 may be a continuous structure covering the entire first surface. In this case, the first semiconductor layer 100 may form one surface of a bifacial solar cell, and may serve as a P region or an N region. Because the first semiconductor layer 100 includes amorphous silicon and/or nanocrystalline silicon. the first semiconductor layer 100 may form a heterojunction structure.

In the foregoing technical solution, a width of the second part 12 ranges from 0.3 mm to 12 mm along a direction from the first part 11 to the second part 12 and perpendicular to a side length of the semiconductor substrate 6. In other words, an edge region ranging from 0.3 mm to 12 mm is reserved surrounding the first part 11, and no laser crystallization processing is performed on the edge region. When the width of the second part 12 is excessively large, a region of the entire first part 11 that has a crystallized structure in the solar cell is small, reduction to a series resistance is small, and a loss during current collection is large. When the width of the second part 12 is excessively small, on one hand, the edge of the first semiconductor layer 100 is limited by a coating craft, and the first semiconductor layer 100 in the edge region is thin, and on the other hand, an angle when the laser is irradiated at an edge of the solar cell is large, and energy distribution in a laser spot is deviated. Consequently, an excessively large energy density of a part of the laser easily causes a damage to passivation of the first semiconductor layer 100 in the edge. Therefore, in consideration of reduction to an overall contact resistance of the solar cell and reduction to the damage to passivation, the width of the second part 12 is selected to range from 0.3 mm to 12 mm.

Further, the width of the second part 12 ranges from 0.3 mm to 3 mm, to further increase an area of the first part 11 of the first semiconductor layer 100, reduce the contact resistance, and improve the cell efficiency. Specifically, the width of the second part 12 may be 0.3 mm, 0.5 mm, 1 mm, 1.5 mm, 2 mm, 2.5 mm, 3 mm, or the like.

For example, for the first semiconductor layer 100 including the plurality of first strip-shaped portions 1, along an extension direction (the first direction) of the first strip-shaped portions 1, an extension length of the second parts 12 at two end edges of the first strip-shaped portion 1 is 1 mm, 1.2 mm, 1.5 mm, or the like. Along a distribution direction (the second direction) of the plurality of first strip-shaped portions 1, degree of crystallizations of two first strip-shaped portions 1 close to two side edges of the first surface are the same as the degree of crystallization of the second part 12.

In an embodiment, a material of the first part 11 includes at least one of amorphous silicon and nanocrystalline silicon. To be specific, the first part 11 may be an amorphous silicon layer, may be a nanocrystalline silicon layer, or a combination of nanocrystalline silicon and amorphous silicon. After the first part 11 is crystallized by using the laser, the degree of crystallization of the first part 11 may be improved. For example, when the first semiconductor layer 100 is an amorphous silicon layer, when a part of the amorphous silicon layer is crystallized by using the laser, nanocrystalline grains are formed. When the first semiconductor layer 100 is a nanocrystalline silicon layer or a combination of amorphous silicon and nanocrystalline silicon, when a part is crystallized by using the laser, a crystallinity or degree of crystallization of the first semiconductor layer 100 may be improved.

A material of the second part 12 may be the amorphous silicon. Therefore, the second part 12 has a good passivation effect. A crystallized region and an uncrystallized region that are both proper are provided on the first semiconductor layer 100, so that the overall cell efficiency of the solar cell is optimized, thereby improving the cell efficiency.

In some implementations, when the first semiconductor layer 100 includes the plurality of first strip-shaped portions 1 extending along the first direction, and the second semiconductor layer 2 includes the plurality of second strip-shaped portions extending along the first direction, a degree of crystallization of at least one first strip-shaped portion 1 close to the edge of the first surface along the second direction is the same as the degree of crystallization of the second part 12. Through such setting, for the strip-shaped first strip-shaped portions 1, the plurality of first strip-shaped portions 1 are arranged along the second direction, and all regions of the at least one first strip-shaped portion 1 close to the edge of the first surface in an arrangement direction has a degree of crystallization the same as that of the second part 12, that is, no laser crystallization processing is performed on the at least one first strip-shaped portion 1 close to the edge, and the remaining first strip-shaped portions 1 from the uncrystallized second parts 12 only on two side edges of the second direction, to implement disposition of an uncrystallized structure on two side edges of the first semiconductor layer 100.

For example, in the second direction, degree of crystallizations of all regions of two strip-shaped portions respectively located on the two edges of the first surface are the same as the degree of crystallization of the second part 12, or degree of crystallizations of two, three, or another quantity of first strip-shaped portions 1 that are reserved close to each edge of the first surface are the same as the degree of crystallization of the second part 12.

As shown in FIG. 5 and FIG. 6, in some possible implementations, the semiconductor substrate 6 includes a recessed part on the first surface. The recessed part includes a side wall and a bottom wall. The recessed part is recessed toward a direction of the second surface relative to another part of the first surface. The first part 11 is located inside the recessed part. Through such setting, the recessed part is formed through etching to a surface of the semiconductor substrate 6, and usually has a textured structure. When the first part 11 having amorphous silicon, nanocrystalline silicon, and/or microcrystalline silicon is disposed in the recessed part, a contact area of the first part 11 can be increased, thereby facilitating current collection.

In some embodiments, a surface that is of the semiconductor substrate 6 and on which an amorphous semiconductor layer is provided is a textured structure. The amorphous semiconductor layer and the textured structure are conformal. The textured structure has a light trapping effect that improve light collection, and the textured structure can be in good contact with an electrode. When laser crystallization is performed on the first part 11 of the first semiconductor layer 100, the laser is irradiated on the textured structure of the first part 11, and a crystallization temperature can be reached, so that a local region of the first part 11 forms a crystallized microcrystalline structure or nanocrystalline structure. In this way, the crystallized region has both an uncrystallized structure and the crystallized structure. The crystallized structure reduces the contact resistance, but reduces the passivation effect, and may increase recombination, which is adverse to photoelectric efficiency. Therefore, the crystallized structure is formed in the local region of a part of the textured structure, so that two factors, namely, the contact resistance and the passivation effect, can be balanced, to optimize the cell efficiency.

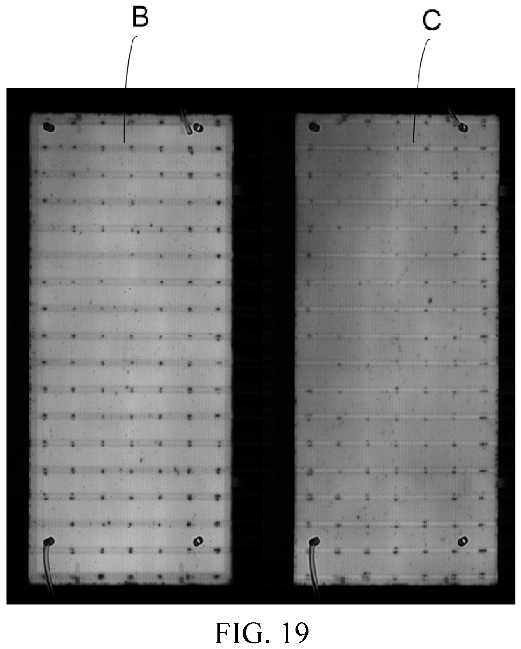

As shown in FIG. 19, in this embodiment, an EL (Electroluminescent, electroluminescent) test of the solar cell is a manner for detecting an internal defect of the solar cell. In an image obtained from the EL test, luminance of the first part 11 having the higher degree of crystallization is higher than luminance of the second part 12 having the lower degree of crystallization. The EL test is performed on the solar cell under a same condition. In an obtained image, when luminance of the first part 11 is higher than luminance of the second part 12, it indicates that a contact resistance of the first part 11 is less than a contact resistance of the second part 12. When the solar cell is powered on and tested, electroluminescent luminance of the first part 11 with the less contact resistance is higher, and electroluminescent luminance of the second part 12 is lower. It can be learned from an image of a solar cell B in FIG. 19 that luminance of a first part 11 of the solar cell B is higher than luminance of a second part 12. As can be learned from comparison with an image of a solar cell C, luminance of an entire surface of the solar cell C is consistent, and is lower in comparison with that of the solar cell B, indicating that an entire contact resistance of the solar cell C is large.

In some possible implementations, the solar cell further includes a first grid electrode 4 extending along the first direction, and the first grid electrode 4 is conductively disposed on the first part 11 of the first semiconductor layer 100. An extension direction of the first grid electrode 4 is consistent with the extension direction of the first strip-shaped portion 1, and carriers of the first part 11 and a part of the second part 12 on the same first semiconductor layer 100 can be collected. Therefore, a capability of collecting carriers of the first semiconductor layer 100 by the first grid electrode 4 can be improved.

For the solar cell having the second semiconductor layer 2, the solar cell further includes a second grid electrode 5 conductively disposed on the second semiconductor layer 2. An extension direction of the second grid electrode 5 is consistent with an extension direction of the second semiconductor layer 2 along the first direction. When the first transparent conductive layer 71 and the second transparent conductive layer 72 are included, the first grid electrode 4 is disposed on the first transparent conductive layer 71, and the second grid electrode 5 is disposed on the second transparent conductive layer 72.

Further, in this embodiment, a ratio of a width of the first grid electrode 4 to a width of the first part 11 along the second direction ranges from 10% to 120%, and may be specifically 10%, 30%, 50%, 80%, 100%, 120%, or the like. A ratio of the width of the first grid electrode 4 to a width of an intermediate part is selected based on a material and a carrier transport capability of the first semiconductor layer 100. If the carrier transport capability of the first semiconductor layer 100 is weak, the ratio of the width of the first grid electrode 4 to the width of the intermediate part is increased, to increase a contact area between the first grid electrode 4 and the intermediate part, and reduce a contact resistance. Otherwise, the ratio of the width of the first grid electrode 4 to the width of the intermediate part may be reduced, to save an electrode material when current collection is satisfied.

For example, the width of the first grid electrode 4 may range from 30 µm to 600 µm. Specifically, when the first grid electrode 4 is prepared by using a screen printing craft, the width of the first grid electrode 4 ranges from 30 µm to 80 µm. When the first grid electrode 4 is prepared in a depositing manner such as electroplating, the width of the first grid electrode 4 ranges from 100 µm to 600 µm. The width of the intermediate part ranges from 200 µm to 700 µm. A proper width of the first grid electrode 4 is selected based on the width of the intermediate part and an electrode preparation craft.

Further, when the solar cell includes the first transparent conductive layer 71, the first grid electrode 4 is disposed extending on the first transparent conductive layer 71 along the first direction. The width of the first grid electrode 4 is less than or equal to a width of the first transparent conductive layer 71 along the second direction, and the width of the first transparent conductive layer 71 is greater than the width of the intermediate part. For example, the width of the first transparent conductive layer 71 ranges from 120 µm to 800 µm, the width of the first part 11 ranges from 200 µm to 700 µm, and a ratio of the width of the first transparent conductive layer 71 to the width of the first part 11 ranges from 1.2 to 1.5. A proper width of the first transparent conductive layer 71 is selected based on the width of the first part 11, and a proper width of the first grid electrode 4 is selected based on the width of the first part 11, the width of the first transparent conductive layer 71, and an electrode preparation craft. Through such setting, the first grid electrode 4 may be disposed right opposite the first part 11, and the width of the first transparent conductive layer 71 is greater than the width of the intermediate part, to improve the current collection capability.

Based on the solar cell described in any one of the foregoing embodiments, an embodiment of the present application further provides a photovoltaic module, including the solar cell described in any one of the foregoing embodiments.

Because the photovoltaic module uses the solar cell described in any one of the foregoing embodiments, the photovoltaic module has beneficial effects the same as those of the foregoing solar cell, and details are not described herein again.

An embodiment of the present application further provides a production method for a solar cell. The production method may be used to prepare the solar cells described in FIG. 1 to FIG. 6 and any one of the foregoing embodiments. The production method for a solar cell includes the following steps.

Step S100: Provide a semiconductor substrate 6, where the semiconductor substrate 6 has a first surface and a second surface opposite to the first surface.

Step S200: Form a first semiconductor layer 100 located on the first surface, where the first semiconductor layer 100 includes at least one of amorphous silicon, nanocrystalline silicon, and microcrystalline silicon.

Step S300: Irradiate a first part 11 of the first semiconductor layer 100 by using laser, and skip irradiating a second part 12 of the first semiconductor layer 100, to enable a degree of crystallization of the first part 11 to be higher than a degree of crystallization of the second part 12, where the first part 11 is adjacent to the second part 12 along a second direction.

When the foregoing technical solution is used, crystallization processing is performed on a region corresponding to the first part 11 located on the first semiconductor layer 100 by using laser, so that a degree of crystallization is improved. A region corresponding to the second part 12 adjacent to the first part 11 on the first semiconductor layer 100 is not irradiated by the laser, and an amorphous structure is retained (it should be noted that, when the first semiconductor layer 100 includes nanocrystalline silicon or microcrystalline silicon, a degree of crystallization or crystallinity of nanocrystalline silicon or microcrystalline silicon of the second part 12 remains unchanged), so that the overall degree of crystallization of the first part 11 of the first semiconductor layer 100 is higher than the overall degree of crystallization of the second part 12. It may be understood that, when other factors are the same, a lower degree of crystallization of a semiconductor layer indicates smaller grains in the semiconductor layer, and even randomness of an amorphous silicon material is presented. Smaller grains in the semiconductor layer indicate more boundaries between the grains in the semiconductor layer. Therefore, a resistance of the grain boundaries is large. Therefore, the crystallized structure in the first part 11 of the first semiconductor layer 100 reduces a contact resistance, so that a contact resistance between the first part 11 and a conductive material (a transparent conductive layer or an electrode) is reduced, thereby helping reduce a transmission loss when carriers collected in the first semiconductor layer 100 are transmitted to the conductive material. In addition, the degree of crystallization of the second part 12 of the first semiconductor layer 100 is lower than the degree of crystallization of the first part 11. This ensures a passivation effect of the second part 12 adjacent to the first part 11 along the second direction, and reduces recombination at an edge of the first semiconductor layer 100. To be specific, for a back contact solar cell, the second part 12 of the first semiconductor layer 100 is close to a second semiconductor layer 2, and the degree of crystallization of the second part 12 is low, to ensure the passivation effect of the second part 12 and avoid electric leakage between the second part 12 and the second semiconductor layer 2. It can be known from the foregoing that a crystallized region and an uncrystallized region that are both proper are provided on the first semiconductor layer 100, so that overall cell efficiency of the solar cell is optimized based on the higher degree of crystallization of the first part 11, thereby improving the cell efficiency. In addition, the passivation effect of the second part 12 is ensured based on the lower degree of crystallization of the second part 12, thereby avoiding electric leakage.

Further, before the first part 11 is irradiated by using the laser, the method further includes the following steps.

Step S201: Form a second semiconductor layer 2 on the first surface. The first semiconductor layer 100 and the second semiconductor layer 2 are arranged adjacently along the second direction. A conductivity type of the first semiconductor layer 100 is different from a conductivity type of the second semiconductor layer 2. The second semiconductor layer 2 has an adjacent side surface close to the first semiconductor layer 100. The second part 12 is closer to the second semiconductor layer 2 than the first part 11.

In this embodiment, the solar cell is a back contact solar cell, the first semiconductor layer 100 and the second semiconductor layer 2 are both provided on the first surface, and the first semiconductor layer 100 and the second semiconductor layer 2 are provided adjacently along the second direction. As shown in FIG. 4 and FIG. 5, the second semiconductor layer 2 has an adjacent side surface close to the first semiconductor layer 100. The second part 12 is closer to the second semiconductor layer 2 than the first part 11 along the second direction. To be specific, the second part 12 is located between the first part 11 and the second semiconductor layer 2 along the second direction. A conductivity type of the first semiconductor layer 100 is different from a conductivity type of the second semiconductor layer 2. To implement arrangement of a P region and an N region on the first surface, the first semiconductor layer 100 is one of the P region and the N region, and the second semiconductor layer 2 is the other of the P region and the N region.

When the foregoing technical solution is used, for a back contact solar cell, the second part 12 of the first semiconductor layer 100 is closer to the second semiconductor layer 2, and the degree of crystallization of the second part 12 is lower, to ensure the passivation effect of the second part 12, avoid electric leakage between the second part 12 and the second semiconductor layer 2, and reduce photoelectric conversion efficiency of the solar cell.

In some possible implementations, the first semiconductor layer 100 includes an amorphous silicon layer. A part of the amorphous silicon layer is crystallized to form nanocrystalline grains after an intermediate part is irradiated by the laser. When the first semiconductor layer 100 uses the amorphous silicon layer, a part that is not irradiated by the laser has a good passivation effect, and a PN isolation region 10 has a better insulation effect.

Further, the first part 11 extends in a strip shape along a first direction. In this case, the irradiate a first part 11 by using laser in step S300 specifically includes the following step.

Step S301: Irradiate the first part 11 along the first direction by using the laser. A start or end position of the laser is away from the adjacent side surface by a first distance along the second direction.

When the foregoing technical solution is used, the second part 12 extends from the edge of the first part 11 to the region S3 shown in FIG. 5, and the first distance is a width of the region S3 along the second direction, that is, there is a spacing between an end away from the first part 11 of the second part 12 and the adjacent side surface. The second part 12 is not in contact with the second semiconductor layer 2, and a spacing between the second part 12 and the second semiconductor layer 2 is large, to help further reduce potential electric leakage between the second part 12 and the second semiconductor layer 2.

Further, the start or end position of the laser is away from a boundary of the first semiconductor layer 100 by a second distance along the first direction. Specifically, the second distance is a distance by which the second part 12 extends along the first direction. Due to the second distance, two ends of the first semiconductor layer 100 along the first direction are not irradiated by the laser, and an amorphous structure is retained. Due to reasons such as full-field non-uniformity of the laser and a non-uniform thickness of the first semiconductor layer 100, when the laser acts on an edge part of the first semiconductor layer 100, the laser causes a damage to passivation of the edge part, and consequently, recombination of the edge part is increased. Therefore, in the present application, the crystallized structure is not formed at two ends of the first semiconductor layer 100 by using the laser, and uncrystallized structures at the two ends of the first semiconductor layer 100 are retained, thereby ensuring a passivation effect of the edge part, and reducing recombination of the edge part.

In the foregoing embodiment, the second distance is greater than the first distance. To be specific, a width of the second part 12 (the second part adjacent to the first part along the second direction) along the first direction is greater than a width of the second part along the second direction. For example, the first distance is less than or equal to 500 µm, and the second distance ranges from 0.3 mm to 12 mm.

In some embodiments, a wavelength of the laser ranges from 325 nm to 532 nm, where the wavelength of the laser may be specifically 325 nm, 450 nm, 532 nm, or the like; and/or an energy density of the laser ranges from 200 mJ/cm² to 6000 mJ/cm². Specifically, the energy density of the laser may be 200 mJ/cm², 500 mJ/cm², 1000 mJ/cm², 2000 mJ/cm², 3000 mJ/cm², 5000 mJ/cm², 6000 mJ/cm², or the like. A pulse width of the laser may be on an order of magnitude ranging from a picosecond to a nanosecond. The range of the wavelength is set, so that the laser can be absorbed by the first semiconductor layer 100, thereby helping implement crystallization of the first semiconductor layer 100. When the energy density of the laser is excessively high, a high-temperature range may be expanded, and a temperature at a top of a textured structure may be excessively high. Consequently, passivation of a top region of the textured structure is affected. When the energy density of the laser is excessively low, energy accumulation duration is excessively long, affecting production efficiency, and energy required for crystallization may not be reached. Therefore, when the energy density of the laser in this range is selected, only the top of the textured structure reaches a high temperature, so that a topography changes, and a crystallized structure is formed.

As shown in FIG. 7 to FIG. 18, this embodiment provides a specific production process for a solar cell. Using an example in which a hybrid back contact solar cell having a tunneling passivated contact structure and a heterojunction structure on a back surface is prepared, a preparation process for the back contact solar cell is as follows:
First step: As shown in FIG. 7, a silicon wafer was polished and cleaned. Specifically, the silicon wafer was placed into a batch-type polishing and cleaning machine for polishing, to remove a cutting damage layer of the silicon wafer. Polished topographies on two surfaces were controlled by controlling a temperature, time, and a concentration of a chemical solution, and an obtained silicon wafer was used as a semiconductor substrate 6. The semiconductor substrate 6 may be an N-type silicon substrate, a p-type silicon substrate, or an intrinsic silicon substrate.

Second step: As shown in FIG. 8, a tunneling oxide layer 21 and an intrinsic polycrystalline silicon layer 23 were successively formed on a back surface of the semiconductor substrate 6. The tunneling oxide layer 21 was an SiOx layer. The tunneling oxide layer 21 and the intrinsic polycrystalline silicon layer 23 may be formed by using one or more crafts such as low pressure chemical vapor deposition, plasma chemical vapor deposition, physical-chemical vapor deposition, or plasma-enhanced atomic layer deposition. In addition, the tunneling oxide layer 21 may be generated through a high-temperature reaction between oxygen and the semiconductor substrate 6, or may be generated by using a wet chemical method, for example, a reaction between silicon and ozone or an oxidation reaction between silicon and nitric acid. A thickness of the tunneling oxide layer 21 ranged from 1 nm to 4 nm. In an embodiment, the thickness was 1.4 nm. A thickness of the intrinsic polycrystalline silicon layer 23 ranged from 30 nm to 250 nm. In an embodiment, the thickness was 120 nm.

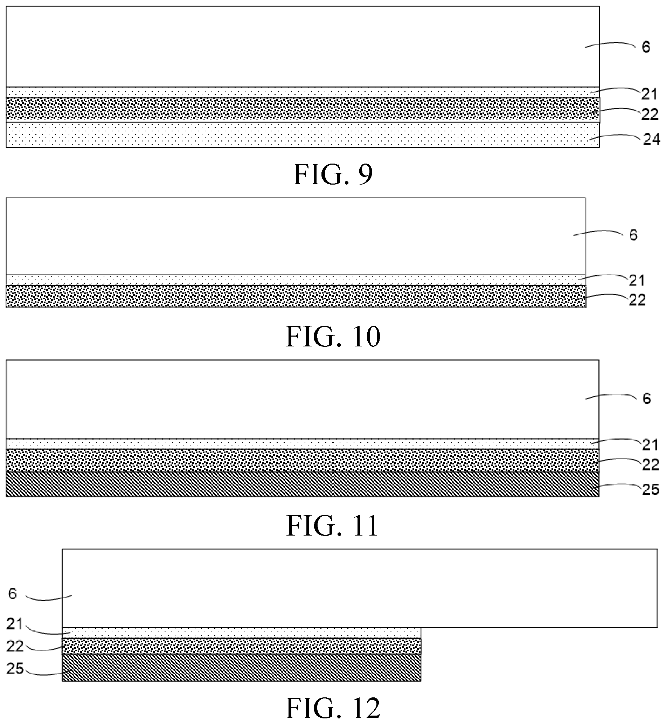

Third step: As shown in FIG. 9, the intrinsic polycrystalline silicon layer 23 was doped through thermal diffusion, to form an N-type doped polycrystalline silicon layer 22, and an oxide layer including phosphorus, that is, a phosphosilicate glass layer 24, was generated. A doping concentration of the N-type doped polycrystalline silicon layer 22 ranged from 1×10¹⁹ cm⁻³ to 5×10²⁰ cm⁻³.

Fourth step: As shown in FIG. 10, the phosphosilicate glass layer 24 formed after phosphorus diffusion was removed by using an HF solution.

Fifth step: As shown in FIG. 11, a silicon nitride mask layer 25 was formed on the N-type doped polycrystalline silicon layer 22 through deposition. A function of the silicon nitride mask layer 25 was to serve as a hydrogen source to provide hydrogen atoms for interfaces of crystalline silicon and the tunneling oxide layer 21, passivate a dangling bond, and passivate a part of defects in the crystalline silicon. The other function was to serve as a mask, to protect the N-region film layer when a P region was subsequently patterned.

Sixth step: As shown in FIG. 12, the P region was patterned by using a laser craft, and laser ablated all P-region film layers until the semiconductor substrate 6. The laser may be generated by a 532 nm laser emitter. For a pulse width, a nanosecond-level laser emitter or a picosecond-level laser emitter may be selected. In an embodiment, a 532 nm picosecond-level laser emitter was selected.

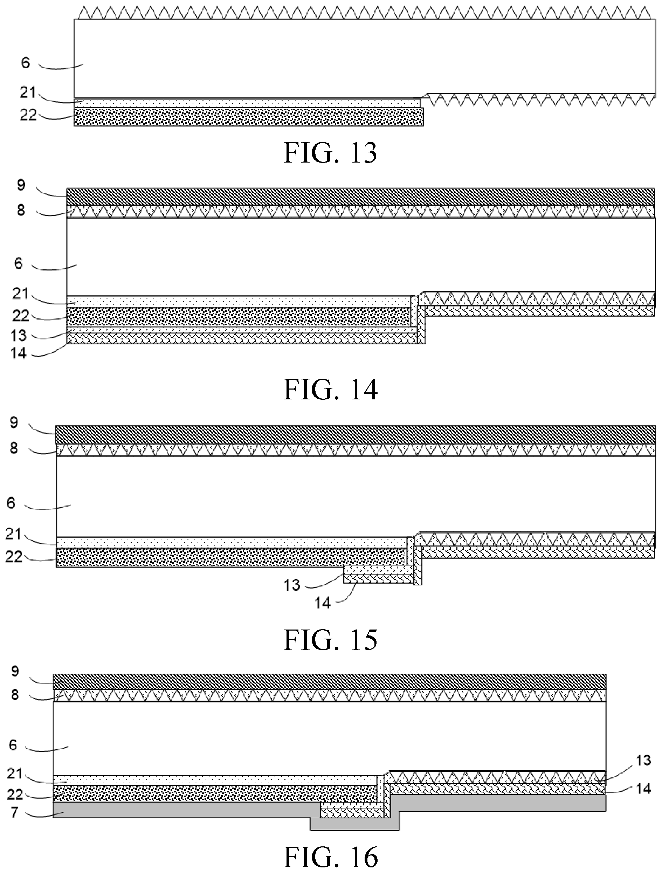

Seventh step: As shown in FIG. 13, texturing was performed on the semiconductor substrate 6 exposed in the P region by using a wet etching craft, to obtain a textured structure, for example, a pyramid structure. Then, the silicon nitride mask layer 25 was removed. A first function of the wet etching craft was to remove a damage layer of the semiconductor substrate 6 in the P region after the laser processing, and perform interface cleaning processing. A second function was to remove the silicon nitride mask layer 25 deposited in the N region.

Eighth step: As shown in FIG. 14, an intrinsic amorphous silicon layer 13 and a p-type amorphous silicon layer 14 were formed on the back surface of the semiconductor substrate 6 through successive deposition, to form a P-region emitter. A thickness of the intrinsic amorphous silicon layer 13 ranged from 2 nm to 20 nm. In an embodiment, the thickness was 8 nm. A thickness of the p-type amorphous silicon layer 14 ranged from 5 nm to 50 nm. In an embodiment, the thickness was 15 nm. Concurrently, deposition was successively performed on a front textured surface of the semiconductor substrate 6 to form a passivation layer 8 and an anti-reflection layer 9. The anti-reflection layer 9 was one or any combination of a plurality of a silicon nitride layer, a silicon oxide layer, and a silicon oxynitride layer. The passivation layer 8 may be an intrinsic amorphous silicon layer or an aluminum oxide layer.

Ninth step: As shown in FIG. 15, the N region was patterned by using the laser craft, and the intrinsic amorphous silicon layer 13 and the p-type amorphous silicon layer 14 on the N-type doped polycrystalline silicon layer 22 were removed, to expose the N-type doped polycrystalline silicon layer 22. An oxide layer was formed on the N-type doped polycrystalline silicon layer 22, and was subsequently removed by using the wet etching craft. A 355 nm or 532 nm laser emitter may be used for the laser. For a pulse width, a nanosecond-level laser emitter or a picosecond-level laser emitter may be selected. In an embodiment, a 532 nm picosecond-level laser emitter was selected. A chained device may be used for the wet etching craft. A front surface of a semi-finished product was placed upward, and was protected by using a water film. A back surface was in contact with the HF solution, to remove the oxide layer and silicon nitride that is wrapped around to the back surface.

Tenth step: As shown in FIG. 15, a region corresponding to a first part 11 of the p-type amorphous silicon layer 14 in the P region was irradiated by using the laser craft, so that the first part having a crystallized structure was formed on the p-type amorphous silicon layer 14. An edge of the p-type amorphous silicon layer 14 along a second direction is not irradiated by the laser, and an origin uncrystallized structure was retained, to form a second part 12. A 355 nm or 532 nm laser emitter may be used for the laser. For a pulse width, a nanosecond-level laser emitter or a picosecond-level laser emitter may be selected. In an embodiment, a 532 nm picosecond-level laser emitter was selected. Specifically, a pulse laser spot was moved and irradiated along an extension direction of the p-type amorphous silicon layer 14. It should be noted that the laser craft in the ninth step and the tenth step may be performed in a same step, and may not be sequentially performed. To reduce laser processing duration, after the P region is patterned by using the laser, crystallization processing is then performed through irradiation.

Eleventh step: As shown in FIG. 16, a transparent conductive layer 7 was deposited on the back surface of the semiconductor substrate 6. The transparent conductive layer 7 may be one or more of fluorine-doped tin oxide, aluminum-doped zinc oxide, indium tin oxide, tungsten-doped indium oxide, indium molybdenum oxide, cerium-doped indium oxide, and indium hydroxide, and may be laminated or single-layer. In an embodiment, an indium tin oxide film layer is used.

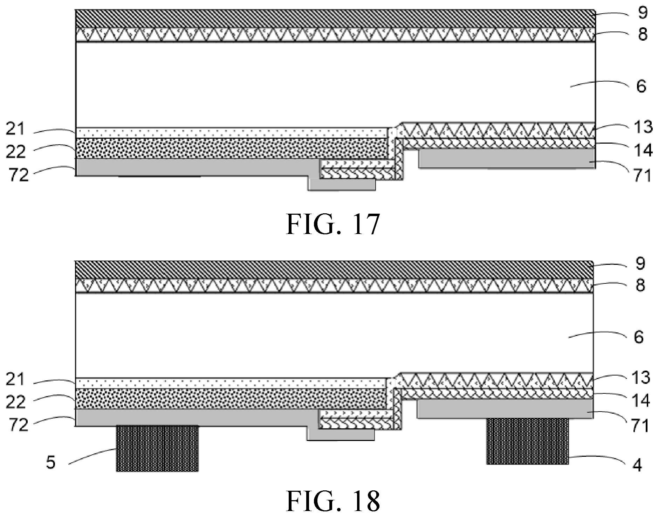

Twelfth step: As shown in FIG. 17, the transparent conductive layer 7 in the N region and the P region was separated, to form a PN isolation region 10, so that the transparent conductive layer 7 was formed into a first transparent conductive layer 71 located in the P region and a second transparent conductive layer 72 located in the N region, to implement insulation between the P region and the N region. The transparent conductive layer 7 was separated at a position close to an edge of the semiconductor substrate 6 in the N region and the P region, to form a third transparent conductive layer 73 located at the edge. The PN isolation region 10 located between the P region and the N region spanned an overlapping region between the N region and the P region and a part of the P region, to implement good insulation.

Thirteenth step: As shown in FIG. 18, a first grid electrode 4 and a second grid electrode 5 were respectively formed on the first transparent conductive layer 71 in the P region and the second transparent conductive layer 72 in the N region through deposition. Two ends of the first grid electrode 4 respectively extended to the second parts 12 on the two sides shown in FIG. 1. Materials of the first grid electrode 4 and the second grid electrode 5 may be one or a combination of a plurality of silver, copper, or aluminum.

In some implementations, a second semiconductor layer 2 of the solar cell in this embodiment of the present application includes a third part 201 and a fourth part 202 that is adjacent to the third part 201 along the second direction. A degree of crystallization of the third part 201 is higher than a degree of crystallization of the fourth part 202. A part of a second part 12 of a first semiconductor layer 100 is disposed above the fourth part 202 of the second semiconductor layer 2 to form an overlapping part.

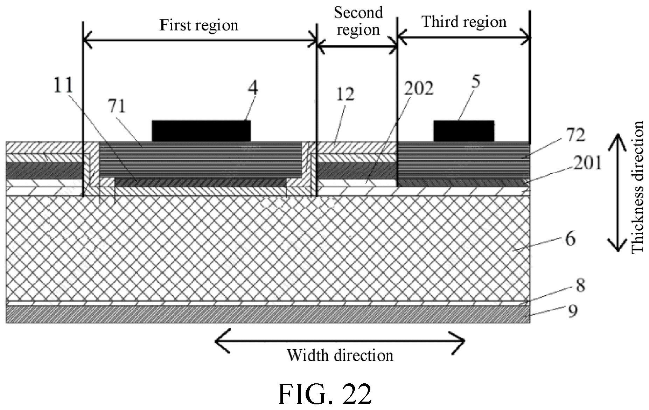

As shown in FIG. 22, a solar cell in an embodiment of the present application includes a semiconductor substrate 6, a first semiconductor layer 100, and a second semiconductor layer 2. The semiconductor substrate 6 has a first surface and a second surface opposite to the first surface. The first semiconductor layer 100 and the second semiconductor layer 2 are both provided on the first surface of the semiconductor substrate 6. The first semiconductor layer 100 includes a first part 11 and a second part 12 that is adjacent to the first part 11 along a second direction. A degree of crystallization of the first part 11 is higher than a degree of crystallization of the second part 12. The second semiconductor layer 2 includes a third part 201 and a fourth part 202 that is adjacent to the third part 201 along the second direction. A degree of crystallization of the third part 201 is higher than a degree of crystallization of the fourth part 202. A part of the second part 12 of the first semiconductor layer 100 is disposed above the fourth part 202 of the second semiconductor layer 2 to form an overlapping part 15.

The second semiconductor layer 2 includes at least one of amorphous silicon, nanocrystalline silicon, and microcrystalline silicon. Forming manner, structures, and the like of the third part 201 and the fourth part 202 are similar to those of the first part 11 and the second part 12, and details are not described herein again.

In other words, the solar cell in this embodiment includes the semiconductor substrate 6 (such as a silicon substrate), and a side surface of the semiconductor substrate 6 includes a first region, a second region, and a third region that are successively adjacent to each other. In the first region, the first semiconductor layer 100 and a first grid electrode 4 are successively stacked on the semiconductor substrate 6. The first semiconductor layer 100 is also referred to as a first doped layer. In the third region, the second semiconductor layer 2 and a second grid electrode 5 are successively stacked on the semiconductor substrate 6. The second semiconductor layer 2 is also referred to as a second doped layer. Conductivity of the first semiconductor layer 100 is opposite to that of the second semiconductor layer 2. The first semiconductor layer 100 and the second semiconductor layer 2 extend to the second region. At least one of the first semiconductor layer 100 in the first region and the second semiconductor layer 2 in the third region has a crystallized region (the first part 11 or the third part 201). In the second region, at least a part of the first semiconductor layer 100 is an uncrystallized region (the second part 12), and at least a part of the second semiconductor layer 2 is an uncrystallized region (the fourth part 202). The second part 12 and the fourth part 202 form an overlapping part 15 in the second region.

In some implementations, when the first doped layer in the first region has a textured surface, only a protrusion part of the textured surface in a laser irradiated region undergoes crystallization, and a recessed part does not undergo crystallization.

In some implementations, when the first doped layer in the first region is a smooth surface, all the first doped layer in the laser irradiated region undergoes crystallization.

In some implementations, when the second doped layer in the third region has a textured surface, only a protrusion part of the textured surface in a laser irradiated region undergoes crystallization, and a recessed part does not undergo crystallization.

In some implementations, when the second doped layer in the third region is a smooth surface, all the second doped layer in the laser irradiated region undergoes crystallization.

In the solar cell in this embodiment, because photogenerated carriers are transferred and diffused transversely (in a direction perpendicular to a thickness direction of a doped layer) and transferred and diffused longitudinally (in a direction parallel to a thickness direction of a doped layer) in doped layers of different doping types, the second region having high resistivity is provided for isolation between the first semiconductor layer 100 in the first region and the second semiconductor layer 2 in the third region, so that transverse transfer of the carriers can be reduced, and electric leakage can be reduced. In addition, the first semiconductor layer 100 in the first region has the first part 11 having a higher degree of crystallization, and the second semiconductor layer 2 in the third region has the third part 201 having a higher degree of crystallization. The crystallized regions have good conductivity, to help carrier collection. In addition, in the second region, the degree of crystallization of the second part 12 in the first semiconductor layer 100 is lower or even the second part 12 is an uncrystallized region, and the degree of crystallization of the fourth part 202 in the second semiconductor layer 2 is lower or even the fourth part 202 is an uncrystallized region. The uncrystallized region has lower carrier mobility and lower sheet resistance than the crystallized region, so that an electric leakage current can be greatly reduced.

In some implementations, the solar cell further includes a first grid electrode 4. The first grid electrode 4 is stacked above the first semiconductor layer 100. A projection of the first grid electrode 4 on the semiconductor substrate 6 overlaps with a projection of the first part 11 on the semiconductor substrate 6. A projection area of the first grid electrode 4 on the semiconductor substrate 6 is less than a projection area of the first part 11 on the semiconductor substrate 6. Generally, the projection of the first grid electrode 4 on the semiconductor substrate 6 completely falls within a range of the projection of the first part 11 on the semiconductor substrate 6, to ensure that a part in contact with the first grid electrode 4 is all the first part 11.

As shown in FIG. 22, the solar cell further includes a second grid electrode 5. The second grid electrode 5 is stacked above the second semiconductor layer 2. A projection of the second grid electrode 5 on the semiconductor substrate 6 overlaps with a projection of the third part 201 on the semiconductor substrate 6. A projection area of the second grid electrode 5 on the semiconductor substrate 6 is less than a projection area of the third part 201 on the semiconductor substrate 6. Generally, the projection of the second grid electrode 5 on the semiconductor substrate 6 completely falls within a range of the projection of the third part 201 on the semiconductor substrate 6, to ensure that a part in contact with the second grid electrode 5 is all the third part 201.

In the solar cell in this embodiment, the projection of the first grid electrode 4 on the semiconductor substrate 6 (for example, a silicon substrate) overlaps the projection of the first part 11 on the semiconductor substrate 6, and the projection area of the first grid electrode 4 on the semiconductor substrate 6 is smaller than the projection area of the first part 11 on the semiconductor substrate 6. In some embodiments, the projection of the first grid electrode 4 on the semiconductor substrate 6 (for example, a silicon substrate) completely falls within the projection of the first part 11 on the semiconductor substrate 6, the projection of the second grid electrode 5 on the semiconductor substrate 6 overlaps with the projection of the third part 201 on the semiconductor substrate 6, and the projection area of the second grid electrode 5 on the semiconductor substrate 6 is smaller than the projection area of the third part 201 on the semiconductor substrate 6. In some embodiments, the projection of the second grid electrode 5 on the semiconductor substrate 6 (for example, a silicon substrate) completely falls within the projection of the third part 201 on the semiconductor substrate 6. Through such setting, when photogenerated carriers are transmitted to the first grid electrode 4/the second grid electrode 5 through the first semiconductor layer 100/the second semiconductor layer 2, a current density herein is highest. Because transmission efficiency of the first part 11 and the third part 201 is higher than that of the second part 12 and the fourth part 202, larger projection areas of the first part 11 and the third part 201 on the semiconductor substrate 6 indicate higher transmission efficiency and a smaller contact resistance.

A preparation method for the solar cell in the foregoing embodiment includes the following steps.

Step 1: Polish and clean a silicon wafer, and perform texturing treatment on a light incident surface.

Step 2: Successively deposit a 5-nm intrinsic hydrogenated amorphous silicon passivation layer, 30-nm amorphous n layer, 100-nm SiNx layer (with a refractive index of 2.5) and a 30-nm laser absorption layer on a back surface of the solar cell through PECVD.

Step 3: Remove a laser absorption layer in a first region by using laser, to form a laser opening and expose the SiNx layer.

Step 4: Remove the SiNx layer in the laser opening through a wet craft by using hydrofluoric acid with a concentration of 10%, to expose the amorphous n layer; and remove the exposed amorphous n layer, the intrinsic hydrogenated amorphous silicon passivation layer below the exposed amorphous n layer, and a laser absorption layer in a second region and a third region by using potassium hydroxide with a concentration of 10%, to expose the silicon wafer in the first region and a silicon nitride layer in the second region and the third region.

Step 5: Successively deposit a 5-nm intrinsic hydrogenated amorphous silicon passivation layer and 30-nm amorphous p layer on both the silicon wafer in the first region and the silicon nitride layer in the second region and the third region on the back surface of the solar cell through PECVD.

Step 6: Remove the amorphous p layer and the intrinsic hydrogenated amorphous silicon passivation layer in the third region by using laser (where a single-spot energy density of the laser is 200 mJ/cm²) to form an opening, to expose an SiNx layer in the third region.

Step 7: Remove the SiNx layer in the third region through wet processing by using hydrofluoric acid with a concentration of 10%.

Step 8: Deposit an intrinsic hydrogenated amorphous silicon passivation layer and an SiNx anti-reflection film on the light incident surface through PECVD, where a refractive index is 2, and a thickness is 70 nm.

Step 9: Perform laser crystallization processing, to crystallize a middle region of an amorphous p layer in the first region into a nanocrystalline p region. To be specific, the first region includes both a first nanocrystalline p-doped region and a first amorphous p-doped region, the first amorphous p-doped region surrounds the first nanocrystalline p-doped region, and a part that is stacked with an electrode and that is on an amorphous n layer in the third region is crystallized into a nanocrystalline n region.

Step 10: Successively deposit a TCO layer and an Ag electrode (a first grid electrode) on a nanocrystalline p layer, and successively deposit a TCO layer and an Ag electrode (a second grid electrode) on a nanocrystalline n layer.

In the descriptions of the foregoing implementations, the described specific features, structures, materials, or characteristics may be combined in a proper manner in any one or more of the embodiments or examples.

The foregoing descriptions are merely specific implementations of the present application, but are not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. A solar cell, comprising:
a semiconductor substrate, wherein the semiconductor substrate has a first surface and a second surface opposite to the first surface; and
a first semiconductor layer provided on the first surface, wherein the first semiconductor layer comprises a first part and a second part that is adjacent to the first part along a second direction, a degree of crystallization of the first part being higher than a degree of crystallization of the second part, and the first semiconductor layer comprising at least one of amorphous silicon, nanocrystalline silicon, and microcrystalline silicon.

2. The solar cell according to claim 1, wherein the solar cell further comprises a second semiconductor layer provided on the first surface, the first semiconductor layer and the second semiconductor layer being arranged adjacently along the second direction, and a conductivity type of the first semiconductor layer being different from a conductivity type of the second semiconductor layer; the second part is closer to the second semiconductor layer than the first part along the second direction; and the second semiconductor layer has an adjacent side surface close to the first semiconductor layer.

3. The solar cell according to claim 2, wherein the second semiconductor layer comprises a third part and a fourth part that is adjacent to the third part along the second direction, a degree of crystallization of the third part being higher than a degree of crystallization of the fourth part, and the second semiconductor layer comprising at least one of amorphous silicon, nanocrystalline silicon, and microcrystalline silicon.

4. The solar cell according to claim 2, wherein the second part extends from an edge of the first part toward the adjacent side surface along the second direction, but is not in contact with the adjacent side surface.

5. The solar cell according to claim 2, wherein the second part extends from an edge of the first part to the adjacent side surface along the second direction, and is in contact with the adjacent side surface.

6. The solar cell according to claim 5, wherein a distance between the edge of the first part and the adjacent side surface along the second direction is greater than or equal to 20 µm.

7. The solar cell according to claim 2, wherein a part of the second part is disposed above the second semiconductor layer to form an overlapping part, the second part extending from an edge of the first part to the overlapping part along the second direction.

8. The solar cell according to claim 1, wherein a width of the second part along the second direction is less than or equal to 500 µm and greater than or equal to 20 µm.

9. The solar cell according to claim 2, wherein the solar cell further comprises a first transparent conductive layer covering the first semiconductor layer, a projection of the first part on the semiconductor substrate completely falling within a projection of the first transparent conductive layer on the semiconductor substrate.

10. The solar cell according to claim 9, wherein the first transparent conductive layer extends, along the second direction, to the adjacent side surface or to the second part located above the second semiconductor layer.

11. The solar cell according to claim 9, wherein the solar cell further comprises a second transparent conductive layer, the second transparent conductive layer covering the second semiconductor layer; and
a PN isolation region is provided between the second transparent conductive layer and the first transparent conductive layer, the PN isolation region being located on the second semiconductor layer.

12. The solar cell according to claim 11, wherein a part of the second part is disposed above the second semiconductor layer to form an overlapping part, the PN isolation region being provided on the overlapping part.

13. The solar cell according to claim 1, wherein the solar cell further comprises a third semiconductor layer provided on the second surface, a material of the third semiconductor layer comprising at least one of polycrystalline silicon, amorphous silicon, nanocrystalline silicon, and microcrystalline silicon, and a conductivity type of the third semiconductor layer being different from a conductivity type of the first semiconductor layer.

14. The solar cell according to claim 1, wherein the first part and the second part both extend in a strip shape along a first direction, the first direction intersecting with the second direction.

15. The solar cell according to claim 1, wherein a contact resistance of the first part is less than a contact resistance of the second part.

16. The solar cell according to claim 1, wherein the first part extends to an edge of the first surface along a first direction.

17. The solar cell according to claim 1, wherein the second part surrounds the first part.

18. The solar cell according to claim 1, wherein a material of the first part comprises amorphous silicon and nanocrystalline silicon, and a material of the second part is amorphous silicon.

19. The solar cell according to claim 1, wherein the semiconductor substrate comprises a recessed part on the first surface, the recessed part being recessed toward a direction of the second surface relative to another part of the first surface, and the first part being located inside the recessed part.

20. The solar cell according to claim 1, wherein the solar cell further comprises a first grid electrode, the first grid electrode being stacked above the first semiconductor layer, a projection of the first grid electrode on the semiconductor substrate overlapping with a projection of the first part on the semiconductor substrate, and a projection area of the first grid electrode on the semiconductor substrate being less than a projection area of the first part on the semiconductor substrate.

21. A photovoltaic module, comprising a solar cell, wherein the solar cell is the solar cell according to any one of claims 1 to 20.

22. A production method for a solar cell, wherein the method comprises:
providing a semiconductor substrate, wherein the semiconductor substrate has a first surface and a second surface opposite to the first surface;
forming a first semiconductor layer located on the first surface, wherein the first semiconductor layer comprises at least one of amorphous silicon, nanocrystalline silicon, and microcrystalline silicon; and
irradiating a first part of the first semiconductor layer by using laser, and skipping irradiating a second part of the first semiconductor layer, to enable a degree of crystallization of the first part to be higher than a degree of crystallization of the second part, wherein the first part is adjacent to the second part along a second direction.

23. The production method for a solar cell according to claim 22, wherein the first semiconductor layer is an amorphous silicon layer, a part of the amorphous silicon layer being crystallized to form nanocrystalline grains after the first part is irradiated by the laser.

24. The production method for a solar cell according to claim 22, wherein before the irradiating a first part by using laser, the method further comprises: forming a second semiconductor layer on the first surface, the first semiconductor layer and the second semiconductor layer being arranged adjacently along the second direction, a conductivity type of the first semiconductor layer being different from a conductivity type of the second semiconductor layer, the second semiconductor layer having an adjacent side surface close to the first semiconductor layer, and the second part being closer to the second semiconductor layer than the first part.

25. The production method for a solar cell according to claim 24, wherein the first part extends in a strip shape along a first direction, and the irradiating a first part by using laser comprises: irradiating the first part along the first direction by using the laser, a start or end position of the laser being away from the adjacent side surface by a first distance along the second direction.

26. The production method for a solar cell according to claim 25, wherein the start or end position of the laser is away from a boundary of the first semiconductor layer by a second distance along the first direction.

27. The production method for a solar cell according to claim 26, wherein the second distance is greater than the first distance.

28. The production method for a solar cell according to claim 22, wherein a wavelength of the laser ranges from 325 nm to 532 nm; and/or
an energy density of the laser ranges from 200 mJ/cm² to 6000 mJ/cm².
